(19) Europäisches Patentamt
European Patent Office
Office européen des brevets

(11) EP 2 733 178 A1

(12) EUROPEAN PATENT APPLICATION
published in accordance with Art. 153(4) EPC

(43) Date of publication:
**21.05.2014 Bulletin 2014/21**

(21) Application number: **12810683.8**

(22) Date of filing: **11.07.2012**

(51) Int Cl.:
***C08L 83/07*** *(2006.01)* ***C08G 77/12*** *(2006.01)*
***C08G 77/20*** *(2006.01)* ***C08L 83/05*** *(2006.01)*
***H01L 33/56*** *(2010.01)*

(86) International application number:
**PCT/JP2012/067681**

(87) International publication number:
**WO 2013/008842 (17.01.2013 Gazette 2013/03)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **14.07.2011 JP 2011155926**
**08.09.2011 JP 2011196538**
**08.09.2011 JP 2011196539**
**02.11.2011 JP 2011240843**

(71) Applicant: **Sekisui Chemical Co., Ltd.**
**Osaka-shi, Osaka 530-8565 (JP)**

(72) Inventors:
- **YAMAZAKI, Ryosuke**
  **Mishima-gun**
  **Osaka 618-0021 (JP)**
- **TANIKAWA, Mitsuru**
  **Mishima-gun**
  **Osaka 618-0021 (JP)**
- **WATANABE, Takashi**
  **Mishima-gun**
  **Osaka 618-0021 (JP)**
- **INUI, Osamu**
  **Mishima-gun**
  **Osaka 618-0021 (JP)**
- **KUNIHIRO, Yoshitaka**
  **Mishima-gun**
  **Osaka 618-0021 (JP)**
- **KIMU, Chizuru**
  **Mishima-gun**
  **Osaka 618-0021 (JP)**
- **KOBAYASHI, Yusuke**
  **Mishima-gun**
  **Osaka 618-0021 (JP)**
- **YASUI, Hidefumi**
  **Mishima-gun**
  **Osaka 618-0021 (JP)**
- **SUEZAKI, Minoru**
  **Mishima-gun**
  **Osaka 618-0021 (JP)**
- **KUSAKA, Yasunari**
  **Mishima-gun**
  **Osaka 618-0021 (JP)**
- **YAMADA, Tasuku**
  **Mishima-gun**
  **Osaka 618-0021 (JP)**

(74) Representative: **Ter Meer Steinmeister & Partner**
**Patentanwälte**
**Mauerkircherstrasse 45**
**81679 München (DE)**

# (54) SEALING AGENT FOR OPTICAL SEMICONDUCTOR DEVICES, AND OPTICAL SEMICONDUCTOR DEVICE

(57) The present invention provides an encapsulant for optical semiconductor devices, which is capable of suppressing surface tackiness of a cured product and is also capable of enhancing the heat resistance and thermal cycle characteristics of the cured product. An encapsulant for optical semiconductor devices according to the present invention which includes: a first organopolysiloxane which is represented by formula (1A) or formula (1B) and has an alkenyl group and a methyl group bonded to a silicon atom; a second organopolysiloxane which is represented by formula (51A) or formula (51B) and has a hydrogen atom bonded to a silicon atom and a methyl group bonded to a silicon atom; and a catalyst for hydrosilylation reaction, and the content ratios of methyl groups bonded to silicon atoms in the first and second organopolysiloxanes each are 80 mol% or more.

$$(R1R2R3SiO_{1/2})_a(R4R5SiO_{2/2})_b(R6SiO_{3/2})_c \quad \text{Formula (1A)}$$

$$(R1R2R3SiO_{1/2})_a(R4R5SiO_{1/2})_b(R6SiO_{3/2})_c \quad \text{Formula (1B)}$$

EP 2 733 178 A1

$(R51R52R53SiO_{1/2})_p(R54R55SiO_{2/2})_q(R56SiO_{3/2})_r$ Formula (51A)

$(R51R52R53SiO_{1/2})_p(R54R55SiO_{2/2})_q(R56SiO_{3/2})_r$ Formula (51B)

[FIG. 1]

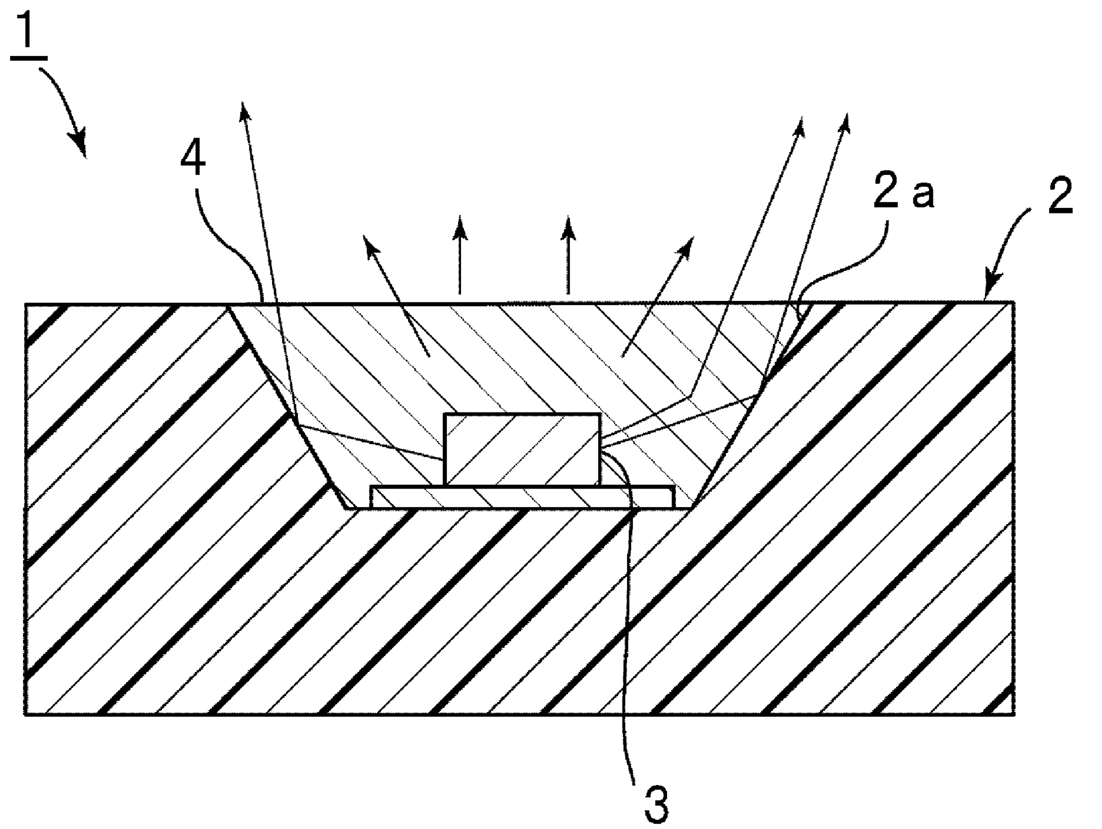

## Description

## TECHNICAL FIELD

The present invention relates to an encapsulant used for encapsulating an optical semiconductor element in an optical semiconductor device. The present invention also relates to an optical semiconductor device using the encapsulant for optical semiconductor devices.

## BACKGROUND ART

Optical semiconductor devices such as light emitting diodes (LED) have low power consumption and a long lifetime. Furthermore, the optical semiconductor devices can be used even under severe conditions. Therefore, the optical semiconductor devices are used in wide range applications such as backlights for mobile phones, backlights for liquid crystal televisions, lamps for automobiles, lighting equipments and signboards.

If an optical semiconductor element (e.g., LED), a light emitting element that is used in an optical semiconductor device, comes into direct contact with the air, light emission properties of the optical semiconductor element are rapidly degraded by moisture in the air, suspending contaminants, or the like. Thus, the optical semiconductor element is normally encapsulated by an encapsulant for optical semiconductor devices.

Patent Document 1 described below discloses, as an encapsulant for optical semiconductor devices, an epoxy resin material containing a hydrogenated bisphenol A glycidyl ether, an alicyclic epoxy monomer and a latent catalyst. The epoxy resin material is cured by thermal cationic polymerization.

Not only an encapsulant for optical semiconductor devices which contains an epoxy resin, but also an encapsulant for optical semiconductor devices which contains a silicone resin is widely used. The silicone resin has high transparency to short-wavelength light in the blue to ultraviolet range, and is excellent in heat resistance and light resistance.

However, when the encapsulant containing the silicone resin is used, there is the problem that since the surface of a cured product of the encapsulant becomes tacky, foreign matters such as contaminants are easily deposited on the surface. There is also the problem that if the surface of the cured product becomes tacky, sticking of packages to each other, and sticking to a pickup nozzle at the time of mounting occur, leading to a significant reduction in productivity of optical semiconductor devices.

On the other hand, as described in Patent Document 2 described below, an encapsulant containing a silicone resin having an increased crosslinking density is known.

## Prior Art Document

### Patent Document

Patent Document 1: JP 2003-73452 A
Patent Document 2: JP 2002-314142 A

## SUMMARY OF THE INVENTION

### PROBLEMS TO BE SOLVED BY THE INVENION

When a conventional encapsulant for optical semiconductor devices described in Patent Document 1 is used in such severe conditions that the encapsulant is repeatedly heated and cooled, cracking may occur in the encapsulant, or the encapsulant may be detached from a housing material or the like.

In the encapsulant described in Patent Document 2, the crosslinking density of a silicone resin contained in the encapsulant is high, and therefore surface tackiness of a cured product is relatively small. However, an encapsulant capable of still further suppressing surface tackiness of the cured product is strongly desired. In the encapsulant described in Patent Document 2, mechanical strength and adhesiveness may be very low. Therefore, when the encapsulant repeatedly undergoes a heat cycle, cracking may occur in the encapsulant, or the encapsulant may be detached from a housing material or the like.

For reflecting light that arrives at the back surface side of a light emitting element, an electrode plated with silver may be formed on the back surface of the light emitting element. If cracking occurs in the encapsulant, or the encapsulant is detached from a housing material, the electrode plated with silver may be exposed to the air. In this case,

plated silver may be discolored by a corrosive gas existing in the air, such as a hydrogen sulfide gas or a sulfurous acid gas. There is such a problem that when the electrode is discolored, the reflectivity decreases, so that the brightness of light emitted by the light emitting element is reduced.

An object of the present invention is to provide an encapsulant for optical semiconductor devices, which is capable of suppressing surface tackiness of a cured product and is also capable of enhancing the heat resistance and thermal cycle characteristics of the cured product, and an optical semiconductor device using the encapsulant for optical semiconductor devices.

## MEANS FOR SOLVING THE PROBLEMS

According to a broad aspect of the present invention, there is provided an encapsulant for optical semiconductor devices, which includes: a first organopolysiloxane having an alkenyl group and a methyl group bonded to a silicon atom; a second organopolysiloxane having a hydrogen atom bonded to a silicon atom and a methyl group bonded to a silicon atom; and a catalyst for hydrosilylation reaction, wherein the first organopolysiloxane is a first organopolysiloxane represented by the following formula (1A) and the second organopolysiloxane is a second organopolysiloxane represented by the following formula (51A), or the first organopolysiloxane is a first organopolysiloxane represented by the following formula (1B) and the second organopolysiloxane is a second organopolysiloxane represented by the following formula (51B), and the content ratios of methyl groups bonded to silicon atoms in the first organopolysiloxane and the second organopolysiloxane each are 80 mol% or more.

[Formula 1] $\mathbf{(R1R2R3SiO_{1/2})_a(R4R5SiO_{2/2})_b(R6SiO_{3/2})_c}$ **Formula (1A)**

In the above formula (1A), a, b and c satisfy a / (a + b + c) = 0 to 0.30, b / (a + b + c) = 0.70 to 1.0 and c / (a + b + c) = 0 to 0.10, at least one of R1 to R6 represents an alkenyl group, at least one of R1 to R6 represents a methyl group, and R1 to R6 other than an alkenyl group and a methyl group represent a hydrocarbon group having 2 to 8 carbon atoms.

[Formula 2] $\mathbf{(R51R52R53SiO_{1/2})_p(R54R55SiO_{2/2})_q(R56SiO_{3/2})_r}$ **Formula (51A)**

In the above formula (51A), p, q and r satisfy p / (p + q + r) = 0.10 to 0.50, q / (p + q + r) = 0 to 0.40 and r / (p + q + r) = 0.40 to 0.90, at least one of R51 to R56 represents a hydrogen atom, at least one of R51 to R56 represents a methyl group, and R51 to R56 other than a hydrogen atom and a methyl group represent a hydrocarbon group having 2 to 8 carbon atoms.

[Formula 3] $\mathbf{(R1R2R3SiO_{1/2})_a(R4R5SiO_{2/2})_b(R6SiO_{3/2})_c}$ **Formula (1B)**

In the above formula (1B), a, b and c satisfy a / (a + b + c) = 0.10 to 0.50, b / (a + b + c) = 0 to 0.40 and c / (a + b + c) = 0.40 to 0.90, at least one of R1 to R6 represents an alkenyl group, at least one of R1 to R6 represents a methyl group, and R1 to R6 other than an alkenyl group and a methyl group represent a hydrocarbon group having 2 to 8 carbon atoms.

[Formula 4] $\mathbf{(R51R52R53SiO_{1/2})_p(R54R55SiO_{2/2})_q(R56SiO_{3/2})_r}$ **Formula (51B)**

In the above formula (51B), p, q and r satisfy p / (p + q + r) = 0 to 0.30, q / (p + q + r) = 0.70 to 1.0 and r / (p + q + r) = 0 to 0.10, at least one of R51 to R56 represents a hydrogen atom, at least one of R51 to R56 represents a methyl group, and R51 to R56 other than a hydrogen atom and a methyl group represent a hydrocarbon group having 2 to 8 carbon atoms.

In a specific aspect of the encapsulant for optical semiconductor devices according to the present invention, a ratio of the content ratio of hydrogen atoms bonded to silicon atoms of the organopolysiloxane in the encapsulant to the content ratio of alkenyl groups bonded to silicon atoms of the organopolysiloxane in the encapsulant (content ratio of hydrogen atoms bonded to silicon atoms / content ratio of alkenyl groups bonded to silicon atoms) is 0.5 or more and 5.0 or less.

In another specific aspect of the encapsulant for optical semiconductor devices according to the present invention, a ratio of the content ratio of hydrogen atoms bonded to silicon atoms of the organopolysiloxane in the encapsulant to the content ratio of alkenyl groups bonded to silicon atoms of the organopolysiloxane in the encapsulant (content ratio of hydrogen atoms bonded to silicon atoms / content ratio of alkenyl groups bonded to silicon atoms) is 0.5 or more and 2.0 or less.

In another specific aspect of the encapsulant for optical semiconductor devices according to the present invention, the first organopolysiloxane is a first organopolysiloxane represented by the above formula (1A), and the second organopolysiloxane is a second organopolysiloxane represented by the above formula (51A).

The number average molecular weight of the first organopolysiloxane represented by the above formula (1A) is preferably 20000 or more and 100000 or less.

In another specific aspect of the encapsulant for optical semiconductor devices according to the present invention, the second organopolysiloxane represented by the above formula (51A) has an alkenyl group.

In another specific aspect of the encapsulant for optical semiconductor devices according to the present invention, the second organopolysiloxane represented by the above formula (51A) has a structural unit represented by the following formula (51-a).

[Formula 5]

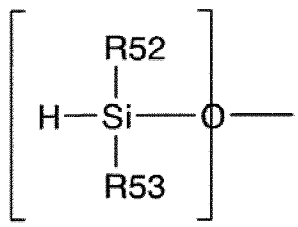

···Formula (51−a)

In the above formula (51-a), R52 and R53 each represent a methyl group or a hydrocarbon group having 2 to 8 carbon atoms.

In another specific aspect of the encapsulant for optical semiconductor devices according to the present invention, the first organopolysiloxane is a first organopolysiloxane represented by the above formula (1B), and the second organopolysiloxane is a second organopolysiloxane represented by the above formula (51B).

The number average molecular weight of the second organopolysiloxane represented by the above formula (51B) is preferably 20000 or more and 100000 or less.

In another specific aspect of the encapsulant for optical semiconductor devices according to the present invention, the first organopolysiloxane represented by the above formula (1B) has a hydrogen atom bonded to a silicon atom.

In another specific aspect of the encapsulant for optical semiconductor devices according to the present invention, the first organopolysiloxane represented by the above formula (1B) has a structural unit represented by the following formula (1-b1).

[Formula 6]

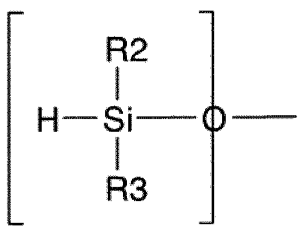

···Formula (1−b1)

In the above formula (1-b1), R2 and R3 each represent a methyl group or a hydrocarbon group having 2 to 8 carbon atoms.

An optical semiconductor device according to the present invention includes: an optical semiconductor element; and the encapsulant for optical semiconductor devices, which is provided to encapsulate the optical semiconductor element.

## EFFECT OF THE INVENTION

An encapsulant for optical semiconductor devices according to the present invention which includes: a first organopolysiloxane having an alkenyl group and a methyl group bonded to a silicon atom; a second organopolysiloxane having a hydrogen atom bonded to a silicon atom and a methyl group bonded to a silicon atom; and a catalyst for hydrosilylation reaction, wherein the first organopolysiloxane is represented by the formula (1A) and the second organopolysiloxane is represented by the formula (51A), or the first organopolysiloxane is represented by the formula (1B)

and the second organopolysiloxane is represented by the formula (51B), and the content ratios of methyl groups bonded to silicon atoms in the first and second organopolysiloxanes each are 80 mol% or more, so that the heat resistance and thermal cycle characteristics of a cured product of the encapsulant are enhanced. Further, tackiness of the surface of the cured product of the encapsulant is suppressed.

## BRIEF DESCRIPTION OF DRAWINGS

Fig. 1 is a front sectional view showing an optical semiconductor device according to one embodiment of the present invention.

## MODE(S) FOR CARRYIG OUT THE INVENTION

Details of the present invention will be described below.

An encapsulant for optical semiconductor devices according to the present invention includes: a first organopolysiloxane; a second organopolysiloxane; and a catalyst for hydrosilylation reaction.

The first organopolysiloxane has an alkenyl group and a methyl group bonded to a silicon atom. The second organopolysiloxane has a hydrogen atom bonded to a silicon atom and a methyl group bonded to a silicon atom.

The first organopolysiloxane is a first organopolysiloxane represented by the formula (1A), or a first organopolysiloxane represented by the formula (1B). The second organopolysiloxane is a second organopolysiloxane represented by the formula (51A), or a second organopolysiloxane represented by the formula (51B). When the first organopolysiloxane is a first organopolysiloxane represented by the formula (1A), the second organopolysiloxane is a second organopolysiloxane represented by the formula (51A). When the first organopolysiloxane is a first organopolysiloxane represented by the formula (1B), the second organopolysiloxane is a second organopolysiloxane represented by the formula (51B).

Thus, in the encapsulant for optical semiconductor devices according to the present invention, the first organopolysiloxane is a first organopolysiloxane represented by the formula (1A) and the second organopolysiloxane is a second organopolysiloxane represented by the formula (51A), or the first organopolysiloxane is a first organopolysiloxane represented by the formula (1B) and the second organopolysiloxane is a second organopolysiloxane represented by the formula (51B). In the encapsulant for optical semiconductor devices according to the present invention, the first organopolysiloxane may be a first organopolysiloxane represented by the formula (1A) and the second organopolysiloxane may be a second organopolysiloxane represented by the formula (51A). Further, in the encapsulant for optical semiconductor devices according to the present invention, the first organopolysiloxane may be a first organopolysiloxane represented by the formula (1B) and the second organopolysiloxane may be a second organopolysiloxane represented by the formula (51B).

Further, in the encapsulant for optical semiconductor devices according to the present invention, the content ratios of methyl groups bonded to silicon atoms in the first organopolysiloxane and the second organopolysiloxane each are 80 mol% or more. The content ratio of methyl groups bonded to silicon atoms is determined in accordance with the following formula (X).

Content ratio of methyl groups bonded to silicon atoms (mol%) = {(average number of methyl groups bonded to silicon atoms contained per molecule of the first organopolysiloxane or the second organopolysiloxane × molecular weight of methyl group) / (average number of functional groups bonded to silicon atoms contained per molecule of the first organopolysiloxane or the second organopolysiloxane × average of molecular weights of functional groups)} × 100 ...formula (X).

The "functional group" in the above formula (X) means a group bonded directly to a silicon atom in the first

organopolysiloxane or the second organopolysiloxane. When there are a plurality of kinds of the functional groups, the "average of molecular weights of functional groups" means a sum of "average number of functional groups $\times$ molecular weight of functional group" for each functional group. The same applies to the "average of molecular weights of functional groups" in the following formula (X1), the following formula (X51), the following formula (Y) and the following formula (Z).

By employing the above-described composition in the encapsulant for optical semiconductor devices according to the present invention, particularly combining the specific first and second organopolysiloxanes described above, the heat resistance of the cured encapsulant can be enhanced. Due to enhancement of the heat resistance of encapsulant, discoloration of the encapsulant can be suppressed even when the encapsulant is exposed under a high temperature, so that the encapsulant is hard to turn yellow. Further, by employment of the above-described composition, the thermal cycle characteristics of the cured encapsulant can be enhanced, and the gas barrier property can be enhanced. Therefore, cracking is hard to occur in the encapsulant, and detachment of the encapsulant can be suppressed. Further, by employment of the above-described composition, surface tackiness of the cured encapsulant can also be suppressed.

A ratio of the content ratio of hydrogen atoms bonded to silicon atoms of the organopolysiloxane in the encapsulant to the content ratio of alkenyl groups bonded to silicon atoms of the organopolysiloxane in the encapsulant (content ratio of hydrogen atoms bonded to silicon atoms / content ratio of alkenyl groups bonded to silicon atoms) is preferably 0.5 or more and 5.0 or less from the viewpoint of effectively enhancing the heat resistance and thermal cycle characteristics of a cured product of the encapsulant. When the first organopolysiloxane has a hydrogen atom bonded to a silicon atom, in the above-described ratio, the content ratio of hydrogen atoms bonded to silicon atoms also includes the content ratio of hydrogen atoms bonded to silicon atoms of the first organopolysiloxane. When the second organopolysiloxane has an alkenyl group bonded to a silicon atom, in the above-described ratio, the content ratio of alkenyl groups bonded to silicon atoms also includes the content ratio of alkenyl groups bonded to silicon atoms of the second organopolysiloxane. Therefore, the above-described ratio (content ratio of hydrogen atoms bonded to silicon atoms / content ratio of alkenyl groups bonded to silicon atoms) means a ratio of the total content ratio of hydrogen atoms bonded to silicon atoms of the first and second organopolysiloxanes in the encapsulant to the total content ratio of alkenyl groups bonded to silicon atoms of the first and second organopolysiloxanes in the encapsulant. The content ratio of hydrogen atoms bonded to silicon atoms is determined in accordance with the following formula (Y). The content ratio of alkenyl groups bonded to silicon atoms is determined in accordance with the following formula (Z).

Content ratio of hydrogen atoms bonded to silicon atoms (mol%) = {(average number of hydrogen atoms bonded to silicon atoms contained per molecule of the first organopolysiloxane × molecular weight of hydrogen atom) / (average number of functional groups bonded to silicon atoms contained per molecule of the first organopolysiloxane × average of molecular weights of functional groups) × blending amount of the first organopolysiloxane in encapsulant / (blending amount of the first organopolysiloxane in encapsulant + blending amount of the second organopolysiloxane in encapsulant)} × 100 + {(average number of hydrogen atoms bonded to silicon atoms contained per molecule of the second organopolysiloxane × molecular weight of hydrogen atom) / (average number of functional groups bonded to silicon atoms contained per molecule of the second organopolysiloxane × average of molecular weights of functional groups) × blending amount of the second organopolysiloxane in encapsulant / (blending amount of the first organopolysiloxane in encapsulant + blending amount of the second organopolysiloxane in encapsulant)} × 100 ...formula (Y).

Content ratio of alkenyl groups bonded to silicon atoms (mol%) = {(average number of alkenyl groups bonded to silicon atoms contained per molecule of the first organopolysiloxane × molecular weight of alkenyl group bonded to silicon atom) / (average number of functional groups bonded to silicon atoms contained per molecule of the first organopolysiloxane × average of molecular weights of functional groups) × blending amount of the first organopolysiloxane in encapsulant / (blending amount of the first organopolysiloxane in encapsulant + blending amount of the second organopolysiloxane in encapsulant)} × 100 + {(average number of alkenyl groups bonded to silicon atoms contained per molecule of the second organopolysiloxane × molecular weight of alkenyl group bonded to silicon atom) / (average number of functional groups bonded to silicon atoms contained per molecule of the second organopolysiloxane × average of molecular weights of functional groups) × blending amount of the second organopolysiloxane in encapsulant / (blending amount of the first organopolysiloxane in encapsulant + blending amount of the second organopolysiloxane in encapsulant))} × 100 ...formula (Z).

When the first organopolysiloxane does not have a hydrogen atom bonded to a silicon atom, the content ratio of hydrogen atoms bonded to silicon atoms of the organopolysiloxane in the encapsulant represents the content ratio of hydrogen atoms bonded to silicon atoms of the second organopolysiloxane. In this case, the content ratio of hydrogen atoms bonded to silicon atoms is determined in accordance with the following formula (Y1).

Content ratio of hydrogen atoms bonded to silicon atoms (mol%) = {(average number of hydrogen atoms bonded to silicon atoms contained per molecule of the first organopolysiloxane × molecular weight of hydrogen atom) / (average number of functional groups bonded to silicon atoms contained per molecule of the first organopolysiloxane × average of molecular weights of functional groups) × blending amount of the first organopolysiloxane in encapsulant / (blending amount of the first organopolysiloxane in encapsulant + blending amount of the second organopolysiloxane in encapsulant)} × 100 ...formula (Y1).

When the second organopolysiloxane does not have an alkenyl group bonded to a silicon atom, the content ratio of alkenyl groups bonded to silicon atoms of the organopolysiloxane in the encapsulant represents the content ratio of alkenyl groups bonded to silicon atoms of the first organopolysiloxane. In this case, the content ratio of alkenyl groups bonded to silicon atoms is determined in accordance with the following formula (Z1).

Content ratio of alkenyl groups bonded to silicon atoms (mol%) = {(average number of alkenyl groups bonded to silicon atoms contained per molecule of the first organopolysiloxane × molecular weight of alkenyl group bonded to silicon atom) / (average number of functional groups bonded to silicon atoms contained per molecule of the first organopolysiloxane × average of molecular weights of functional groups) × blending amount of the first organopolysiloxane in encapsulant / (blending amount of the first organopolysiloxane in encapsulant + blending amount of the second organopolysiloxane in encapsulant)} × 100 ...formula (Z1).

The above-described ratio (content ratio of hydrogen atoms bonded to silicon atoms / content ratio of alkenyl groups bonded to silicon atoms) is preferably 1.0 or more from the viewpoint of further enhancing the heat resistance of the encapsulant.

The above-described ratio (content ratio of hydrogen atoms bonded to silicon atoms / content ratio of alkenyl groups bonded to silicon atoms) is preferably 0.5 or more and 2.0 or less, more preferably 0.5 or more and 1.1 or less, from the viewpoint of further enhancing the reliability of the optical semiconductor device using the encapsulant. When the above-described ratio is 2.0 or less, the hardness is hard to be increased even if the encapsulant is stored at a high temperature for a long term. Suppression of an increase in hardness at a high temperature leads to reduction of a thermal stress generated during a thermal cycle, and therefore contributes to reliability of the optical semiconductor device using the encapsulant.

Details of components contained in the encapsulant for optical semiconductor devices according to the present invention will be described below.

(First organopolysiloxane)

The first organopolysiloxane contained in the encapsulant for optical semiconductor devices according to the present invention is represented by the following formula (1A) or the following formula (1B), and has an alkenyl group and a methyl group bonded to a silicon atom. The first organopolysiloxane preferably has two or more alkenyl groups. The first organopolysiloxane may have a hydrogen atom bonded to a silicon atom, or may not have a hydrogen atom bonded to a silicon atom. The alkenyl group is preferably directly bonded to a silicon atom. A carbon atom in the carbon-carbon double bond in the alkenyl group may be bonded to a silicon atom, or a carbon atom different from the carbon atom in the carbon-carbon double bond in the alkenyl group may be bonded to a silicon atom. The methyl group is directly bonded to a silicon atom. The first organopolysiloxane described above may be used alone, or in combination of two or more kinds.

[Formula 7] $\mathbf{(R1R2R3SiO_{1/2})_a(R4R5SiO_{2/2})_b(R6SiO_{3/2})_c}$ **Formula (1A)**

In the above formula (1A), a, b and c satisfy a / (a + b + c) = 0 to 0.30, b / (a + b + c) = 0.70 to 1.0 and c / (a + b + c) = 0 to 0.10, at least one of R1 to R6 represents an alkenyl group, at least one of R1 to R6 represents a methyl group, and R1 to R6 other than an alkenyl group and a methyl group represent a hydrocarbon group having 2 to 8 carbon atoms.

[Formula 8] $\mathbf{(R1R2R3SiO_{1/2})_a(R4R5SiO_{2/2})_b(R6SiO_{3/2})_c}$ **Formula (1B)**

In the above formula (1B), a, b and c satisfy a / (a + b + c) = 0.10 to 0.50, b / (a + b + c) = 0 to 0.40 and c / (a + b + c) = 0.40 to 0.90, at least one of R1 to R6 represents an alkenyl group, at least one of R1 to R6 represents a methyl group, and R1 to R6 other than an alkenyl group and a methyl group represent a hydrocarbon group having 2 to 8 carbon atoms.

In the above formula (1A) and the above formula (1B), a structural unit represented by ($R4R5SiO_{2/2}$) and a structural unit represented by ($R6SiO_{3/2}$) may each have an alkoxy group, or may each have a hydroxy group.

The above formula (1A) and the above formula (1B) each show an average composition formula. The hydrocarbon groups in the above formula (1A) and the above formula (1B) may be linear or may be branched. R1 to R6 in the above formula (1A) and the above formula (1B) may be the same or may be different.

In the above formula (1A) and the above formula (1B), oxygen atom moieties in the structural units represented by ($R4R5SiO_{2/2}$) and ($R6SiO_{3/2}$) each show an oxygen atom moiety forming a siloxane bond, an oxygen atom moiety of an alkoxy group, or an oxygen atom moiety of a hydroxy group.

Generally, in each structural unit in the above formula (1A) and the above formula (1B), the content of the alkoxy group is low, and further the content of the hydroxy group is also low. This is because generally, when an organic silicon compound such as an alkoxysilane compound is hydrolyzed and subjected to polycondensation for obtaining a first organopolysiloxane, many of alkoxy groups and hydroxy groups are converted into the siloxane bond partial backbone. That is, many of oxygen atoms of the alkoxy groups and oxygen atoms of the hydroxy groups are converted into oxygen atoms that form the siloxane bond. When each structural unit in the above formula (1A) and the above formula (1B) has alkoxy groups or hydroxy groups, the unreacted alkoxy groups or hydroxy groups which have not been converted into the siloxane bond partial backbone will slightly remains. The same holds true for a case where each structural unit in the formula (51A) and the formula (51B) described later has an alkoxy group or a hydroxy group.

Examples of the alkenyl group in the above formula (1A) and the above formula (1B) include a vinyl group, an allyl group, a butenyl group, a pentenyl group, a hexenyl group and the like. The alkenyl group in the above formula (1A) and the above formula (1B) are preferably a vinyl group or an allyl group, more preferably a vinyl group, from the viewpoint of further enhancing the gas barrier property.

The first organopolysiloxane represented by the above formula (1B) preferably has a hydrogen atom bonded to a silicon atom from the viewpoint of further enhancing the curability of the encapsulant. In this case, in the above

formula (1B), at least one of R1 to R6 represents an alkenyl group, at least one of R1 to R6 represents a methyl group, at least one of R1 to R6 represents a hydrogen atom, and R1 to R6 other than an alkenyl group, a methyl group and a hydrogen atom represent a hydrocarbon group having 2 to 8 carbon atoms. The alkenyl group in the first organopolysiloxane is preferably a vinyl group.

The hydrocarbon group having 2 to 8 carbon atoms in the above formula (1A) and the above formula (1B) is not particularly limited, and examples thereof include an ethyl group, a n-propyl group, a n-butyl group, a n-pentyl group, a n-hexyl group, a n-heptyl group, a n-octyl group, an isopropyl group, an isobutyl group, a sec-butyl group, a t-butyl group, an isopentyl group, a neopentyl group, a t-pentyl group, an isohexyl group, a cyclohexyl group and an aryl group.

From the viewpoint of enhancing the curability of the encapsulant and further suppressing cracking and detachment in the heat cycle, the first organopolysiloxane preferably includes a structural unit in which one vinyl group and two hydrocarbon groups having 1 to 8 carbon atoms (methyl group or hydrocarbon group having 2 to 8 carbon atoms) are bonded to one silicon atom, and in the above formula (1A), the structural unit represented by ($R1R2R3SiO_{1/2}$) preferably includes a structural unit in which R1 represents a vinyl group, and R2 and R3 represent a methyl group or a hydrocarbon group having 2 to 8 carbon atoms. That is, the first organopolysiloxane represented by the above formula (1A) preferably includes a structural unit represented by ($CH_2=CHR2R3SiO_{1/2}$), and preferably includes a structural unit represented by the following formula (1-a), from the viewpoint of enhancing the curability of the encapsulant and further suppressing cracking and detachment in the heat cycle. The structural unit represented by ($R1R2R3SiO_{1/2}$) may include only a structural unit represented by the following formula (1-a), or may include a structural unit represented by the following formula (1-a) and a structural unit other than the structural unit represented by the following formula (1-a). Existence of the structural unit represented by the following formula (1-a) allows a vinyl group to exist at the terminal, and existence of the vinyl group at the terminal increases the opportunity of reaction, so that the curability of the encapsulant can be further enhanced. In the structural unit represented by the following formula (1-a), the terminal oxygen atom generally forms a siloxane bond with an adjacent silicon atom, and shares an oxygen atom with an adjacent structural unit. Therefore, one terminal oxygen atom is expressed as "$O_{1/2}$".

[Formula 9]

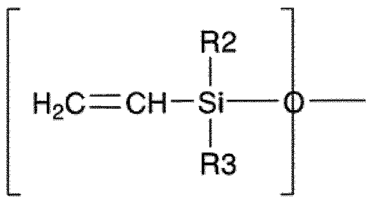

··· Formula (1−a)

In the above formula (1-a), R2 and R3 each represent a methyl group or a hydrocarbon group having 2 to 8 carbon atoms.

From the viewpoint of enhancing the curability of the encapsulant and further suppressing surface tackiness, the first organopolysiloxane preferably includes a structural unit in which one vinyl group and three oxygen atoms forming a siloxane bond are bonded to one silicon atom, and the structural unit represented by ($R6SiO_{3/2}$) in the above formula (1B) preferably includes a structural unit in which R6 represents a vinyl group. That is, the organopolysiloxane represented by the above formula (1B) preferably includes a structural unit represented by ($CH_2=CHSiO_{3/2}$), and preferably includes a structural unit represented by the following formula (1-a2), from the viewpoint of enhancing the curability of the encapsulant and further suppressing surface tackiness. The structural unit represented by ($R6SiO_{3/2}$) may include only a structural unit represented by the following formula (1-a2), or may include a structural unit represented by the following formula (1-a2) and a structural unit other than the structural unit represented by the following formula (1-a2). Due to existence of the structural unit represented by the following formula (1-a2), the vinyl group reacts to form a tetrafunctional siloxane backbone, and the crosslinking density of the encapsulant is increased, so that surface tackiness can be further reduced. In the structural unit represented by the following formula (1-a2), the terminal oxygen atom generally forms a siloxane bond with an adjacent silicon atom, and shares an oxygen atom with an adjacent structural unit. Therefore, three terminal oxygen atoms are expressed as "$O_{3/2}$".

[Formula 10]

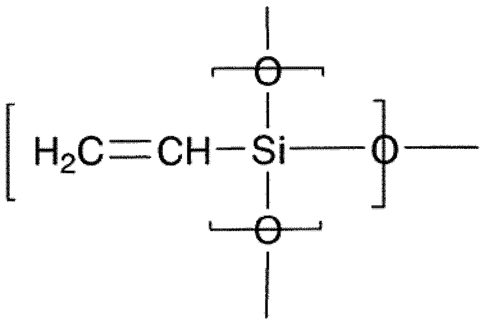

··· Formula (1−a2)

From the viewpoint of enhancing the curability of the encapsulant and further suppressing cracking and detachment in the heat cycle, the first organopolysiloxane preferably includes a structural unit in which one hydrogen atom and two hydrocarbon groups having 1 to 8 carbon atoms (methyl group or hydrocarbon group having 2 to 8 carbon atoms) are bonded to one silicon atom, and in the above formula (1B), the structural unit represented by ($R1R2R3SiO_{1/2}$) preferably includes a structural unit in which R1 represents a hydrogen atom, and R2 and R3 represent a methyl group or a hydrocarbon group having 2 to 8 carbon atoms. That is, the second organopolysiloxane represented by the above formula (1B) preferably includes a structural unit represented by ($HR2R3SiO_{1/2}$), and preferably includes a structural unit represented by the following formula (1-b1), from the viewpoint of enhancing the curability of the encapsulant and further suppressing cracking and detachment in the heat cycle. The structural unit represented by ($R1R2R3SiO_{1/2}$) may include only a structural unit represented by the following formula (1-b1), or may include a structural unit represented by the following formula (1-b1) and a structural unit other than the structural unit represented by the following formula (1-b1). Existence of the structural unit represented by the following formula (1-b1) allows a hydrogen atom to exist at the terminal. Existence of the hydrogen atom at the terminal increases the opportunity of reaction, so that the curability of the encapsulant can be further enhanced. In the structural unit represented by the following formula (1-b1), the terminal oxygen atom generally forms a siloxane bond with an adjacent silicon atom, and shares an oxygen atom with an adjacent structural unit. Therefore, one terminal oxygen atom is expressed as "$O_{1/2}$".

[Formula 11]

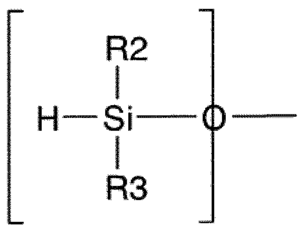

··· Formula (1−b1)

In the above formula (1-b1), R2 and R3 each represent a methyl group or a hydrocarbon group having 2 to 8 carbon atoms.

The content ratio of methyl groups bonded to silicon atoms in the first organopolysiloxane is 80 mol% or more. When the content ratio of methyl groups is 80 mol% or more, the heat resistance of the encapsulant is significantly enhanced, and even if the optical semiconductor device is used in an energized state in severe conditions under a high temperature and high humidity, the luminous intensity is hard to be reduced and discoloration of the encapsulant is hard to occur. The content ratio of methyl groups bonded to silicon atoms in the first organopolysiloxane is preferably 85 mol% or more, further preferably 90 mol% or more, and preferably 99.99 mol% or less, more preferably 99.9 mol% or less, further preferably 99 mol% or less, especially preferably 98 mol% or less. When the content ratio of methyl groups is not less than the lower limit described above, the heat resistance of the encapsulant is further enhanced. When the content ratio of methyl groups is not more than the upper limit described above, alkenyl groups can be sufficiently introduced, so that the curability of the encapsulant is easily enhanced. The content ratio of methyl groups bonded to silicon atoms in the first organopolysiloxane is determined in accordance with the following formula (X1).

Content ratio of methyl groups bonded to silicon atoms (mol%) = {(average number of methyl groups bonded to silicon atoms contained per molecule of the first organopolysiloxane × molecular weight of methyl group) / (average number of functional groups bonded to silicon atoms contained per molecule of the first organopolysiloxane × average

of molecular weights of functional groups) × 100 ...formula (X1).

In the first organopolysiloxane represented by the above formula (1A) and the above formula (1B), the structural unit represented by ($R4R5SiO_{2/2}$) (hereinafter, also referred to as a bifunctional structural unit) may include a structure represented by the following formula (1-2), i.e., a structure in which one of oxygen atoms bonded to a silicon atom in the bifunctional structural unit forms a hydroxy group or an alkoxy group.

($R4R5SiXO_{1/2}$) formula (1-2)

The structural unit represented by ($R4R5SiO_{2/2}$) may include a part, surrounded by a dashed line, of a structural unit represented by the following formula (1-b), and further include a part, surrounded by a dashed line, of a structural unit represented by the following formula (1-2-b). That is, a structural unit, which has groups represented by R4 and R5 and in which an alkoxy group or a hydroxy group remains at the terminal, is also included in the structural unit represented by ($R4R5SiO_{2/2}$). Specifically, when the alkoxy group is converted into a partial backbone of the siloxane bond, the structural unit represented by ($R4R5SiO_{2/2}$) shows a part, surrounded by a dashed line, of the structural unit represented by the following formula (1-b). When an unreacted alkoxy group remains, or when an alkoxy group is converted into a hydroxy group, the structural unit having a remaining alkoxy group or hydroxy group and represented by ($R4R5SiO_{2/2}$) shows a part, surrounded by a dashed line, of the structural unit represented by the following formula (1-2-b). In the structural unit represented by the following formula (1-b), the oxygen atom in the Si-O-Si bond forms a siloxane bond with an adjacent silicon atom, and shares an oxygen atom with an adjacent structural unit. Therefore, one oxygen atom in the Si-O-Si bond is expressed as "$O_{1/2}$".

[Formula 12]

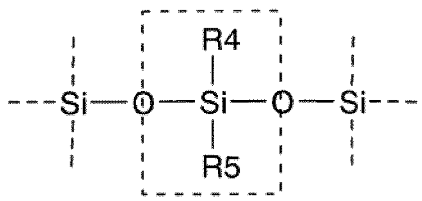

··· Formula (1−b)

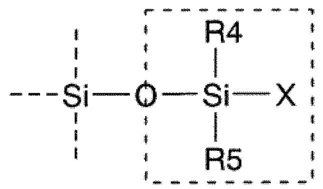

··· Formula (1−2−b)

In the above formula (1-2) and formula (1-2-b), X represents OH or OR, and OR represents a linear or branched alkoxy group having 1 to 4 carbon atoms. R4 and R5 in the above formula (1-b), formula (1-2) and formula (1-2-b) are the same groups as R4 and R5 in the above formula (1A) and the above formula (1B).

In the first organopolysiloxane represented by the above formula (1A) and the above formula (1B), the structural unit represented by ($R6SiO_{3/2}$) (hereinafter, referred to as a trifunctional structural unit) may include a structure represented by the following formula (1-3) or formula (1-4), i.e., a structure in which two of oxygen atoms bonded to a silicon atom in the trifunctional structural unit each form a hydroxy group or an alkoxy group, or a structure in which one of oxygen atoms bonded to a silicon atom in the trifunctional structural unit forms a hydroxy group or an alkoxy group.

($R6SiX_2O_{1/2}$) formula (1-3)

($R6SiXO_{2/2}$) formula (1-4)

The structural unit represented by ($R6SiO_{3/2}$) may include a part, surrounded by a dashed line, of the structural unit represented by the following formula (1-c), and further include a part, surrounded by a dashed line, of a structural unit represented by the following formula (1-3-c) or formula (1-4-c). That is, a structural unit, which has a group represented by R6 and in which an alkoxy group or a hydroxy group remains at the terminal, is also included in the structural unit represented by ($R6SiO_{3/2}$).

[Formula 13]

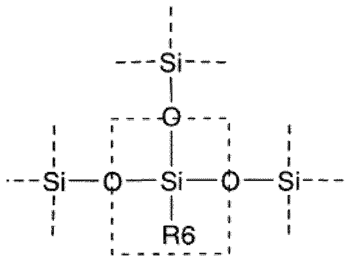

··· Formula (1-c)

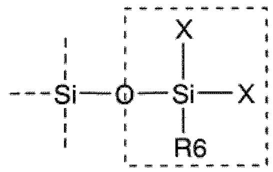

··· Formula (1-3-c)

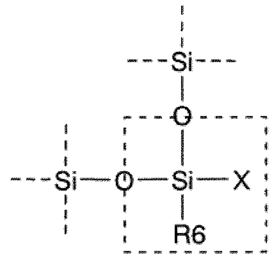

···Formula(1-4-c)

In the above formula (1-3), formula (1-3-c), formula (1-4) and formula (1-4-c), X represents OH or OR, and OR represents a linear or branched alkoxy group having 1 to 4 carbon atoms. R6 in the above formulae (1-c), (1-3), (1-3-c), (1-4) and (1-4-c) is the same group as R6 in the above formula (1A) and the above formula (1B).

In the above formula (1-b) and formula (1-c), the above formula (1-2) to formula (1-4), and the above formula (1-2-b), formula (1-3-c) and formula (1-4-c), the linear or branched alkoxy group having 1 to 4 carbon atoms is not particularly limited, and examples thereof include a methoxy group, an ethoxy group, a n-propoxy group, a n-butoxy group, an isopropoxy group, an isobutoxy group, a sec-butoxy group and a t-butoxy group.

In the above formula (1A), the lower limit of a / (a + b + c) is 0, and the upper limit thereof is 0.30. When a / (a + b + c) is not more than the above-described upper limit, the heat resistance of the encapsulant is further enhanced, and detachment of the encapsulant can be further suppressed. In the above formula (1A), a / (a + b + c) is preferably 0.25 or less, more preferably 0.20 or less. When a is 0, and a / (a + b + c) is 0, the structural unit of ($R1R2R3SiO_{1/2}$) does not exist in the above formula (1A).

In the above formula (1A), the lower limit of b / (a + b + c) is 0.70, and the upper limit thereof is 1.0. When b / (a + b + c) is not more than the above-described lower limit, a cured product of the encapsulant does not become too hard, and cracking is hard to occur in the encapsulant. In the above formula (1A), b / (a + b + c) is preferably 0.75 or more, more preferably 0.80 or more, further preferably 0.85 or more.

In the above formula (1A), the lower limit of c / (a + b + c) is 0, and the upper limit thereof is 0.10. When c / (a + b + c) is not more than the above-described upper limit, a proper viscosity as the encapsulant is easily maintained, so that the adhesion of the encapsulant is further enhanced. In the above formula (1A), c / (a + b + c) is preferably 0.05 or less. When c is 0, and c / (a + b + c) is 0, the structural unit of ($R6SiO_{3/2}$) does not exist in the above formula (1A).

When the first organopolysiloxane is a first organopolysiloxane represented by the formula (1A), c / (a + b + c) in the above formula (1A) is preferably 0. That is, the first organopolysiloxane represented by the above formula (1A) is preferably a first organopolysiloxane represented by the following formula (1Aa). Consequently, cracking is further hard to occur in the encapsulant, and the encapsulant is further hard to be detached from a housing material or the like.

[Formula 14] $\mathbf{(R1R2R3SiO_{1/2})_a(R4R5SiO_{2/2})_b}$ **Formula (1Aa)**

In the above formula (1Aa), a and b satisfy a / (a + b) = 0 to 0.30 and b / (a + b) = 0.70 to 1.0, at least one of R1 to R5 represents an alkenyl group, at least one of R1 to R5 represents a methyl group, and R1 to R5 other than an alkenyl group and a methyl group represent a hydrocarbon group having 2 to 8 carbon atoms.

In the above formula (1Aa), a / (a + b) is preferably 0.25 or less, more preferably 0.20 or less, further preferably 0.15 or less. In the above formula (1Aa), b /(a+b) is preferably 0.75 or more, more preferably 0.80 or more, further preferably 0.85 or more.

In the above formula (1B), the lower limit of a / (a + b + c) is 0.10, and the upper limit thereof is 0.50. When a / (a + b + c) is not more than the above-described upper limit, the heat resistance of the encapsulant is further enhanced, and surface tackiness of the encapsulant can be further suppressed.

In the above formula (1B), the lower limit of b / (a + b + c) is 0, and the upper limit thereof is 0.40. When b / (a + b + c) is not more than the above-described upper limit, detachment of the encapsulant can be further suppressed, and surface tackiness of the encapsulant can be further suppressed. When b is 0, and b / (a + b + c) is 0, the structural unit of ($R4R5SiO_{2/2}$) does not exist in the above formula (1B).

In the above formula (1B), the lower limit of c / (a + b + c) is 0.40, and the upper limit thereof is 0.90. When c / (a + b + c) is not less than the above-described lower limit, the heat resistance of the encapsulant is further enhanced, and surface tackiness of the encapsulant can be further suppressed.

When for the first organopolysiloxane, $^{29}$Si-nuclear magnetic resonance analysis (hereinafter referred to as NMR) is performed using tetramethylsilane (hereinafter referred to as TMS) as the reference, peaks corresponding to the structural units represented by ($R1R2R3SiO_{1/2}$) in the above formula (1A), the above formula (1Aa) and the above formula (1B) appear at around +10 to -5 ppm, peaks corresponding to the structural units represented by ($R4R5SiO_{2/2}$) in the above formula (1A), the above formula (1Aa) and the above formula (1B) and the bifunctional structural unit in the above formula (1-2) appear at around -10 to -50 ppm, and peaks corresponding to the structural unit represented by ($R6SiO_{3/2}$) in the above formula (1A) and the above formula (1B) and the trifunctional structural units in the above formula (1-3) and the above formula (1-4) appear at around -50 to -80 ppm, although there is a slight variation depending on the kind of a substituent.

Therefore, the ratios of the structural units in the above formula (1A), the above formula (1Aa) and the above formula (1B) can be determined by measuring $^{29}$Si-NMR, and comparing the peak areas of signals with one another.

However, if structural units in the above formula (1A), the above formula (1Aa) and the above formula (1B) cannot be identified in the measurement of $^{29}$Si-NMR using TMS as the reference, the ratios of the structural units in the above formula (1A), the above formula (1Aa) and the above formula (1B) can be identified by using not only the result of the measurement of $^{29}$Si-NMR but also the result of the measurement of $^{1}$H-NMR as necessary.

(Second organopolysiloxane)

The second organopolysiloxane contained in the encapsulant for optical semiconductor devices according to the present invention has a hydrogen atom bonded to a silicon atom and a methyl group bonded to a silicon atom. The second organopolysiloxane preferably has two or more hydrogen atoms bonded to silicon atoms. The hydrogen atom and the methyl group are directly bonded to a silicon atom. The second organopolysiloxane described above may be used alone, or in combination of two or more kinds.

[Formula 15] $\mathbf{(R51R52R53SiO_{1/2})_p\ (R54R55SiO_{2/2})_q\ (R56SiO_{3/2})_r}$ **Formula (51A)**

In the above formula (51A), p, q and r satisfy p / (p + q + r) = 0.10 to 0.50, q / (p + q + r) = 0 to 0.40 and r / (p + q + r) = 0.40 to 0.90, at least one of R51 to R56 represents a hydrogen atom, at least one of R51 to R56 represents a methyl group, and R51 to R56 other than a hydrogen atom and a methyl group represent a hydrocarbon group having 2 to 8 carbon atoms.

[Formula 16] $\mathbf{(R51R52R53SiO_{1/2})_p(R54R55SiO_{2/2})_q(R56SiO_{3/2})_r}$ **Formula (51B)**

In the above formula (51B), p, q and r satisfy p / (p + q + r) = 0 to 0.30, q / (p + q + r) = 0.70 to 1.0 and r / (p + q + r) = 0 to 0.10, at least one of R51 to R56 represents a hydrogen atom, at least one of R51 to R56 represents a methyl group, and R51 to R56 other than a hydrogen atom and a methyl group represent a hydrocarbon group having 2 to 8 carbon atoms.

In the above formula (51A) and the above formula (51B), a structural unit represented by ($R54R55SiO_{2/2}$) and a structural unit represented by ($R56SiO_{3/2}$) may each have an alkoxy group, or may each have a hydroxy group.

The above formula (51A) and the above formula (51B) each show an average composition formula. The hydrocarbon groups in the above formula (51A) and the above formula (51B) may be linear or may be branched. R51 to R56 in the above formula (51A) and the above formula (51B) may be the same or may be different.

In the above formula (51A) and the above formula (51B), oxygen atom moieties in the structural units represented by ($R54R55SiO_{2/2}$) and ($R56SiO_{3/2}$) each show an oxygen atom moiety forming a siloxane bond, an oxygen atom moiety of an alkoxy group, or an oxygen atom moiety of a hydroxy group.

The hydrocarbon group having 2 to 8 carbon atoms in the above formula (51A) and the above formula (51B) is not particularly limited, and examples thereof include an ethyl group, a n-propyl group, a n-butyl group, a n-pentyl group, a n-hexyl group, a n-heptyl group, a n-octyl group, an isopropyl group, an isobutyl group, a sec-butyl group, a t-butyl group, an isopentyl group, a neopentyl group, a t-pentyl group, an isohexyl group, a cyclohexyl group, a vinyl group, an allyl group and an aryl group.

From the viewpoint of enhancing the curability of the encapsulant and further suppressing cracking and detachment in the heat cycle, the second organopolysiloxane preferably includes a structural unit in which one hydrogen atom and two hydrocarbon groups having 1 to 8 carbon atoms (methyl group or hydrocarbon group having 2 to 8 carbon atoms) are bonded to one silicon atom, and in the above formula (51A) and the above formula (51B), the structural unit represented by ($R51R52R53SiO_{1/2}$) preferably includes a structural unit in which R51 represents a hydrogen atom, and R52 and R53 represent a methyl group or a hydrocarbon group having 2 to 8 carbon atoms. That is, the second organopolysiloxane preferably includes a structural unit represented by ($HR52R53SiO_{1/2}$), and preferably includes a structural unit represented by the following formula (51-a), from the viewpoint of enhancing the curability of the encapsulant

and further suppressing cracking and detachment in the heat cycle. The structural unit represented by ($R51R52R53SiO_{1/2}$) may include only a structural unit represented by the following formula (51-a), or may include a structural unit represented by the following formula (51-a) and a structural unit other than the structural unit represented by the following formula (51-a). Existence of the structural unit represented by the following formula (51-a) allows a hydrogen atom to exist at the terminal. Existence of the hydrogen atom at the terminal increases the opportunity of reaction, so that the curability of the encapsulant can be further enhanced. In the structural unit represented by the following formula (51-a), the terminal oxygen atom generally forms a siloxane bond with an adjacent silicon atom, and shares an oxygen atom with an adjacent structural unit. Therefore, one terminal oxygen atom is expressed as "$O_{1/2}$".

[Formula 17]

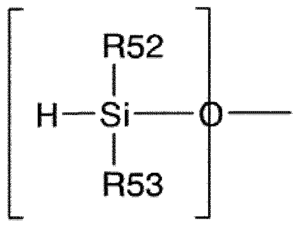

···Formula (51−a)

In the above formula (51-a), R52 and R53 each represent a methyl group or a hydrocarbon group having 2 to 8 carbon atoms.

From the viewpoint of further enhancing the curability of the encapsulant and further suppressing cracking and detachment in the heat cycle, the first organopolysiloxane preferably includes a structural unit represented by the above formula (1-a), and the second organopolysiloxane preferably includes a structural unit represented by the following formula (51-a).

The second organopolysiloxane represented by the above formula (51A) preferably has an alkenyl group bonded to a silicon atom from the viewpoint of further enhancing the curability of the encapsulant. In this case, at least one of R51 to R56 represents a hydrogen atom, at least one of R51 to R56 represents a methyl group, at least one of R51 to R56 represents an alkenyl group, and R51 to R56 other than a hydrogen atom, a methyl group and an alkenyl group represent a hydrocarbon group having 2 to 8 carbon atoms.

The content ratio of methyl groups bonded to silicon atoms in the second organopolysiloxane is 80 mol% or more. When the content ratio of methyl groups is 80 mol% or more, the heat resistance of the encapsulant is significantly enhanced, and even if the optical semiconductor device is used in an energized state in severe conditions under a high temperature and high humidity, the luminous intensity is hard to be reduced and discoloration of the encapsulant is hard to occur. The content ratio of methyl groups bonded to silicon atoms in the second organopolysiloxane is preferably 85 mol% or more, and preferably 99.99 mol% or less, more preferably 99.9 mol% or less, further preferably 99 mol% or less, especially preferably 98 mol% or less. When the content ratio of methyl groups is not less than the lower limit described above, the heat resistance of the encapsulant is further enhanced. When the content ratio of methyl groups is not more than the upper limit described above, hydrogen atoms bonded to silicon atoms can be sufficiently introduced, so that the curability of the encapsulant is easily enhanced. The content ratio of methyl groups bonded to silicon atoms in the second organopolysiloxane is determined in accordance with the following formula (X51).

Content ratio of methyl groups bonded to silicon atoms (mol%) = {(average number of methyl groups bonded to silicon atoms contained per molecule of the second organopolysiloxane $\times$ molecular weight of methyl group) / (average number of functional groups bonded to silicon atoms contained per molecule of the second organopolysiloxane $\times$ average of molecular weights of functional groups) $\times$ 100 formula (X51).

In the second organopolysiloxane represented by the above formula (51A) and the above formula (51B), the structural unit represented by ($R54R55SiO_{2/2}$) (hereinafter, also referred to as a bifunctional structural unit) may include a structure represented by the following formula (51-2), i.e., a structure in which one of oxygen atoms bonded to a silicon atom in the bifunctional structural unit forms a hydroxy group or an alkoxy group.

($R54R55SiXO_{1/2}$) formula (51-2)

The structural unit represented by ($R54R55SiO_{2/2}$) may include a part, surrounded by a dashed line, of a structural unit represented by the following formula (51-b), and further include a part, surrounded by a dashed line, of a structural unit represented by the following formula (51-2-b). That is, a structural unit, which has groups represented by R54 and R55 and in which an alkoxy group or a hydroxy group remains at the terminal, is also included in the structural unit represented by ($R54R55SiO_{2/2}$).

[Formula 18]

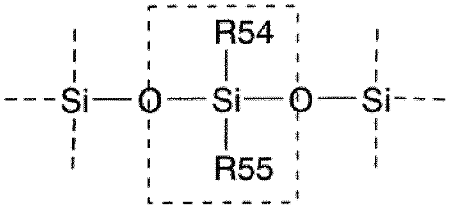

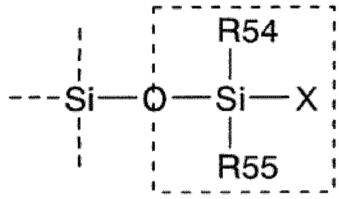

・・・Formula (51−b)　　・・・Formula (51−2−b)

In the above formula (51-2) and formula (51-2-b), X represents OH or OR, and OR represents a linear or branched alkoxy group having 1 to 4 carbon atoms. R54 and R55 in the above formula (51-b), formula (51-2) and formula (51-2-b) are the same groups as R54 and R55 in the above formula (51A) and the above formula (51B).

In the second organopolysiloxane represented by the above formula (51A) and the above formula (51B), the structural unit represented by $(R56SiO_{3/2})$ (hereinafter, referred to as a trifunctional structural unit) may include a structure represented by the following formula (51-3) or formula (51-4), i.e., a structure in which two of oxygen atoms bonded to a silicon atom in the trifunctional structural unit each form a hydroxy group or an alkoxy group, or a structure in which one of oxygen atoms bonded to a silicon atom in the trifunctional structural unit forms a hydroxy group or an alkoxy group.

$(R56SiX_2O_{1/2})$　　formula (51-3)

$(R56SiXO_{2/2})$　　formula (51-4)

The structural unit represented by $(R56SiO_{3/2})$ may include a part, surrounded by a dashed line, of a structural unit represented by the following formula (51-c), and further include a part, surrounded by a dashed line, of a structural unit represented by the following formula (51-3-c) or formula (51-4-c). That is, a structural unit, which has a group represented by R56 and in which an alkoxy group or a hydroxy group remains at the terminal, is also included in the structural unit represented by $(R56SiO_{3/2})$.

[Formula 19]

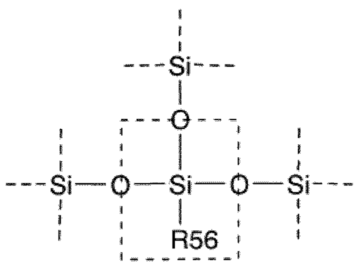

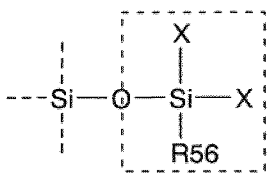

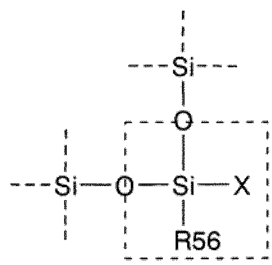

・・・Formula (51−c)　　・・・Formula (51−3−c)　　・・・Formula (51−4−c)

In the above formula (51-3), formula (51-3-c), formula (51-4) and formula (51-4-c), X represents OH or OR, and OR represents a linear or branched alkoxy group having 1 to 4 carbon atoms. R56 in the above formula (51-c), formula (51-3), formula (51-3-c), formula (51-4) and formula (51-4-c) is the same group as R56 in the above formula (51A) and the above formula (51B).

In the above formula (51-b) and formula (51-c), the above formula (51-2) to formula (51-4), and the above formula (51-2-b), formula (51-3-c) and formula (51-4-c), the linear or branched alkoxy group having 1 to 4 carbon atoms is not particularly limited, and examples thereof include a methoxy group, an ethoxy group, a n-propoxy group, a n-butoxy group, an isopropoxy group, an isobutoxy group, a sec-butoxy group and a t-butoxy group.

In the above formula (51A), the lower limit of p / (p + q + r) is 0.10, and the upper limit thereof is 0.50. When p / (p + q + r) is not more than the above-described upper limit, the heat resistance of the encapsulant is further enhanced,

and surface tackiness of the encapsulant can be further suppressed. In the above formula (51A), p / (p + q + r) is preferably 0.40 or less, more preferably 0.35 or less.

In the above formula (51A), the lower limit of q / (p + q + r) is 0, and the upper limit thereof is 0.40. When q / (p + q + r) is not more than the above-described upper limit, detachment of the encapsulant can be further suppressed, and surface tackiness of the encapsulant can be further suppressed. In the above formula (51A), q / (p + q + r) is preferably 0.10 or more, and preferably 0.35 or less. When q is 0, and q / (p + q + r) is 0, the structural unit of ($R54R55SiO_{2/2}$) does not exist in the above formula (51A).

In the above formula (51A), the lower limit of r / (p + q + r) is 0.40, and the upper limit thereof is 0.90. When r / (p + q + r) is not less than the above-described lower limit, detachment of the encapsulant can be further suppressed, and surface tackiness of the encapsulant can be further suppressed. In the above formula (51A), r / (p + q + r) is preferably 0.80 or less, more preferably 0.70 or less.

In the above formula (51B), the lower limit of p / (p + q + r) is 0, and the upper limit thereof is 0.30. When p / (p + q + r) is not more than the above-described upper limit, the heat resistance of the encapsulant is further enhanced, and detachment of the encapsulant can be further suppressed. In the above formula (51B), p / (p + q + r) is preferably 0.25 or less, more preferably 0.20 or less. When p is 0, and p / (p + q + r) is 0, the structural unit of ($R51R52R53SiO_{1/2}$) does not exist in the above formula (51B).

In the above formula (51B), the lower limit of q / (p + q + r) is 0.70, and the upper limit thereof is 1.0. When q / (p + q + r) is not less than the above-described lower limit, a cured product of the encapsulant does not become too hard, and cracking is hard to occur in the encapsulant. In the above formula (51B), q / (p + q + r) is preferably 0.75 or more, more preferably 0.80 or more, further preferably 0.85 or more.

In the above formula (51B), the lower limit of r / (p + q + r) is 0, and the upper limit thereof is 0.10. When r / (p + q + r) is not more than the above-described upper limit, a proper viscosity as the encapsulant is easily maintained, so that the adhesion of the encapsulant is further enhanced. In the above formula (51B), r / (p + q + r) is preferably 0.05 or less. When r is 0, and r / (p + q + r) is 0, the structural unit of ($R56SiO_{3/2}$) does not exist in the above formula (51B).

When the second organopolysiloxane is a second organopolysiloxane represented by the formula (51B), r / (p + q + r) in the above formula (51B) is preferably 0. That is, the second organopolysiloxane represented by the above formula (51B) is preferably a second organopolysiloxane represented by the following formula (51Bb). Consequently, cracking is further hard to occur in the encapsulant, and the encapsulant is further hard to be detached from a housing material or the like.

[Formula 20] $\mathbf{(R51R52R53SiO_{1/2})_p(R54R55SiO_{2/2})_q}$ **Formula(51Bb)**

In the above formula (51Bb), p and q satisfy p / (p + q) = 0 to 0.30 and q / (p + q) = 0.70 to 1.0, at least one of R51 to R55 represents a hydrogen atom, at least one of R51 to R55 represents a methyl group, and R51 to R55 other than a hydrogen atom and a methyl group represent a hydrocarbon group having 2 to 8 carbon atoms.

In the above formula (51Bb), p / (p + q) is preferably 0.25 or less, more preferably 0.20 or less, further preferably 0.15 or less. In the above formula (51Bb), q / (p + q) is preferably 0.70 or more, more preferably 0.80 or more, further preferably 0.85 or more.

When for the second organopolysiloxane, $^{29}$Si-nuclear magnetic resonance analysis (hereinafter referred to as NMR) is performed using tetramethylsilane (hereinafter referred to as TMS) as the reference, peaks corresponding to the structural units represented by ($R51R52R53SiO_{1/2}$) in the above formula (51A), the above formula (51B) and the above formula (51Bb) appear at around +10 to -5 ppm, peaks corresponding to the structural units represented by ($R54R55SiO_{2/2}$) in the above formula (51A), the above formula (51B) and the above formula (51Bb) and the bifunctional structural unit in the above formula (51-2) appear at around -10 to -50 ppm, and peaks corresponding to the structural unit represented by ($R56SiO_{3/2}$) in the above formula (51A) and the above formula (51B) and the trifunctional structural units in the above formula (51-3) and the above formula (51-4) appear at around -50 to -80 ppm, although there is a slight variation depending on the kind of a substituent.

Therefore, the ratios of the structural units in the above formula (51A), the above formula (51B) and the above formula (51Bb) can be determined by measuring $^{29}$Si-NMR, and comparing the peak areas of signals with one another.

However, if structural units in the above formula (51A), the above formula (51B) and the above formula (51Bb) cannot be identified in the measurement of $^{29}$Si-NMR using TMS as the reference, the ratios of the structural units in the above formula (51A), the above formula (51B) and the above formula (51Bb) can be identified by using not only the result of the measurement of $^{29}$Si-NMR but also the result of the measurement of $^{1}$H-NMR as necessary.

The content of the second organopolysiloxane is preferably 10 parts by weight or more and 400 parts by weight or less based on 100 parts by weight of the first organopolysiloxane. When the contents of the first and second organopolysiloxanes fall within this range, an encapsulant that is further excellent in curability can be obtained. From the viewpoint of obtaining an encapsulant which is further excellent in curability, the content of the second organopolysiloxane is more preferably 15 parts by weight or more, further preferably 20 parts by weight or more, and more preferably 300

parts by weight or less, further preferably 200 parts by weight or less, based on 100 parts by weight of the first organopolysiloxane.

(Other natures of first and second organopolysiloxanes and method for synthesis thereof)

The content of alkoxy groups of the first and second organopolysiloxanes is preferably 0.1 mol% or more, and preferably 10 mol% or less, more preferably 5 mol% or less. When the content of alkoxy groups is not less than the above-described lower limit, the adhesion of the encapsulant is enhanced. When the content of alkoxy groups is not more than the above-described upper limit, the storage stability of the first and second organopolysiloxanes and the encapsulant is enhanced, and the heat resistance of the encapsulant is further enhanced.

The content of the alkoxy group refers to an amount of alkoxy groups contained in the average composition of the first and second organopolysiloxanes.

The first and second organopolysiloxanes preferably contain no silanol group. When the first and second organopolysiloxanes contain no silanol group, the storage stability of the first and second organopolysiloxanes and the encapsulant is enhanced. The silanol group can be reduced by heating under vacuum. The content of the silanol group can be measured using infrared spectroscopy.

The number average molecular weights of the first organopolysiloxane represented by the above formula (1A) and the second organopolysiloxane represented by the above formula (51B) each are preferably 10000 or more, more preferably 20000 or more, and preferably 100000 or less, from the viewpoint of adjusting the viscosity of the encapsulant to fall within a preferable range. From the viewpoint of adjusting the viscosity of the encapsulant to fall within a preferable range, the number average molecular weights of the second organopolysiloxane represented by the above formula (51A) and the first organopolysiloxane represented by the above formula (1B) each are preferably 1000 or more, more preferably 2000 or more, and preferably 10000 or less.

From the viewpoint of further suppressing cracking and detachment in the thermal cycle, the number average molecular weights of the first organopolysiloxane represented by the above formula (1A) and the second organopolysiloxane represented by the above formula (51B) each are preferably 20000 or more, and it is considered that the higher the number average molecular weight is more preferred. However, since the alkenyl group on the above formula (1A) and the hydrogen atom in the above formula (51B) are preferably located at the terminal of the organopolysiloxane from the viewpoint of further suppressing cracking and detachment in the thermal cycle, the content ratios of alkenyl groups and hydrogen atoms may be decreased as the above-described number average molecular weight is increased. The content ratio of alkenyl groups in the above formula (1A) and the content ratio of hydrogen atoms bonded to silicon atoms in the above formula (51B) each are preferably 0.05 mol% or more, more preferably 0.3 mol% or more, from the viewpoint of reducing surface tackiness of the encapsulant.

The number average molecular weights of the first organopolysiloxane represented by the above formula (1A) and the second organopolysiloxane represented by the above formula (51B) each are preferably 50000 or less from the viewpoint of suppressing surface tackiness of the encapsulant. Particularly, when the content ratio of alkenyl groups in the above formula (1A) and the content ratio of hydrogen atoms bonded to silicon atoms in the above formula (51B) are not less than the above-described lower limit, surface tackiness of the encapsulant can be effectively suppressed as long as the number average molecular weights of the first organopolysiloxane represented by the above formula (1A) and the second organopolysiloxane represented by the above formula (51B) are 50000 or less.

The number average molecular weight (Mn) is a value determined with polystyrene as a standard substance using gel permeation chromatography (GPC). The number average molecular weight (Mn) refers to a value measured by using a measuring apparatus manufactured by Waters Corporation (column: two pieces of Shodex GPC LF-804 (length: 300 mm) manufactured by SHOWA DENKO K.K.; measurement temperature: 40°C; flow rate: 1 mL/min; solvent: tetrahydrofuran; standard substance: polystyrene).

The method for synthesis of the first and second organopolysiloxanes is not particularly limited, and examples thereof include a method in which an alkoxysilane compound is hydrolyzed and subjected to a condensation reaction, and a method in which a chlorosilane compound is hydrolyzed and condensed. Particularly, the method in which an alkoxysilane compound is hydrolyzed and condensed is preferred from the viewpoint of control of the reaction.

Examples of the method in which an alkoxysilane compound is hydrolyzed and subjected to a condensation reaction include a method in which an alkoxysilane compound is reacted in the presence of water and an acidic catalyst or a basic catalyst. A disiloxane compound may be hydrolyzed and used.

Examples of the organic silicon compound for introducing an alkenyl group into the first organopolysiloxane include vinyltrimethoxysilane, vinyltriethoxysilane, vinylmethyldimethoxysilane, methoxydimethylvinylsilane, vinyldimethylethoxysilane, 1,3-divinyl-1,1,3,3-tetramethyldisiloxane and the like.

Examples of the organic silicon compound for introducing a hydrogen atom bonded to a silicon atom into the second organopolysiloxane include trimethoxysilane, triethoxysilane, methyldimethoxysilane, methyldiethoxysilane, 1,1,3,3-tetramethyldisiloxane and the like.

Examples of other organic silicon compounds that can be used for obtaining the first and second organopolysiloxanes include trimethylmethoxysilane, trimethylethoxysilane, dimethyldimethoxysilane, dimethyldiethoxysilane, isopropyl(methyl)dimethoxysilane, cyclohexyl(methyl)dimethoxysilane, methyltrimethoxysilane, methyltriethoxysilane, ethyltrimethoxysilane, ethyltriethoxysilane, hexyltrimethoxysilane, octyltrimethoxysilane and the like.

Examples of the organic silicon compound for introducing an aryl group into the first and second organopolysiloxanes as necessary include triphenylmethoxysilane, triphenylethoxysilane, diphenyldimethoxysilane, diphenyldiethoxysilane, methyl(phenyl)dimethoxysilane, phenyltrimethoxysilane and the like.

Examples of the acidic catalyst include an inorganic acid, an organic acid, an acid anhydride of an inorganic acid and a derivative thereof, and an acid anhydride of an organic acid and a derivative thereof.

Examples of the inorganic acid include hydrochloric acid, phosphoric acid, boric acid and carbonic acid. Examples of the organic acid include formic acid, acetic acid, propionic acid, butyric acid, lactic acid, malic acid, tartaric acid, citric acid, oxalic acid, malonic acid, succinic acid, glutaric acid, adipic acid, fumaric acid, maleic acid and oleic acid.

Examples of the basic catalyst include a hydroxide of an alkali metal, an alkoxide of an alkali metal and a silanol compound of an alkali metal.

Examples of the hydroxide of an alkali metal include sodium hydroxide, potassium hydroxide and cesium hydroxide. Examples of the alkoxide of an alkali metal include sodium-t-butoxide, potassium-t-butoxide and cesium-t-butoxide.

Examples of the silanol compound of an alkali metal include a sodium silanolate compound, a potassium silanolate compound and a cesium silanolate compound. Particularly, a potassium-based catalyst and a cesium-based catalyst are preferred.

(Catalyst for hydrosilylation reaction)

The catalyst for hydrosilylation reaction contained in the encapsulant for optical semiconductor devices according to the present invention is a catalyst for subjecting to a hydrosilylation reaction between an alkenyl group in the first organopolysiloxane and a hydrogen atom bonded to a silicon atom in the second organopolysiloxane.

As the catalyst for hydrosilylation reaction, various kinds of catalysts that allow the hydrosilylation reaction to proceed can be used. The catalyst for hydrosilylation reaction may be used alone, or in combination of two or more kinds.

Examples of the catalyst for hydrosilylation reaction include a platinum-based catalyst, a rhodium-based catalyst, a palladium-based catalyst and the like. The platinum-based catalyst is preferred because it can enhance the transparency of the encapsulant.

Examples of the platinum-based catalyst include a platinum powder, chloroplatinic acid, a platinum-alkenylsiloxane complex, a platinum-olefin complex and a platinum-carbonyl complex. Particularly, the platinum-alkenylsiloxane complex or the platinum-olefin complex is preferred.

Examples of the alkenylsiloxane in the platinum-alkenylsiloxane complex include 1,3-divinyl-1,1,3,3-tetramethyldisiloxane, 1,3,5,7-tetramethyl-1,3,5,7-tetravinylcyclotetrasiloxane and the like. Examples of the olefin in the platinum-olefin complex include an allyl ether, 1,6-heptadiene and the like.

It is preferred to add an alkenylsiloxane, an organosiloxane oligomer, an allyl ether or an olefin to the platinum-alkenylsiloxane complex or the platinum-olefin complex because the stability of the platinum-alkenylsiloxane complex and platinum-olefin complex can be improved. The alkenylsiloxane is preferably 1,3-divinyl-1,1,3,3-tetramethyldisiloxane. The organosiloxane oligomer is preferably a dimethylsiloxane oligomer. The olefin is preferably 1,6-heptadiene.

The catalyst for hydrosilylation reaction is preferably an alkenyl complex of platinum from the viewpoint of further suppressing a reduction in luminous intensity when the encapsulant is used in an energized state in severe conditions under a high temperature or under a high humidity and further suppressing discoloration of the encapsulant. The alkenyl complex of platinum is preferably an alkenyl complex of platinum which is obtained by reacting a chloroplatinic acid hexahydrate with an alkenyl compound of 6 or more equivalents having two or more functionalities, from the viewpoint of further suppressing a reduction in luminous intensity when the encapsulant is used in an energized state in severe conditions under a high temperature or under a high humidity and further suppressing discoloration of the encapsulant. In this case, the alkenyl complex of platinum is a reaction product of a chloroplatinic acid hexahydrate and an alkenyl compound of 6 or more equivalents having two or more functionalities. By use of the alkenyl complex of platinum, the transparency of the encapsulant can also be enhanced. The alkenyl complex of platinum may be used alone, or in combination of two or more kinds.

As a platinum raw material for obtaining the alkenyl complex of platinum, the chloroplatinic acid hexahydrate ($H_2PtCl_6 \cdot 6H_2O$) is preferably used.

Examples of the alkenyl compound of 6 or more equivalents having two or more functionalities, for obtaining the alkenyl of platinum include 1,3-divinyl-1,1,3,3-tetramethyldisiloxane, 1,3-dimethyl-1,3-diphenyl-1,3-divinyldisiloxane, 1,3,5,7-tetramethyl-1,3,5,7-tetravinylcyclotetrasiloxane and the like.

Regarding the "equivalent" in the alkenyl compound of 6 or more equivalents having two or more functionalities,

a weight, at which the amount of the alkenyl compound having two or more functionalities is 1 mole per mole of the chloroplatinic acid hexahydrate, is 1 equivalent. The amount of the alkenyl compound of 6 or more equivalents having two or more functionalities is preferably 50 equivalents or less.

Examples of the solvent used for obtaining the alkenyl complex of platinum include alcoholic solvents such as methanol, ethanol, 2-propanol and 1-butanol. Aromatic solvents such as toluene and xylene may be used. The solvent may be used alone, or in combination of two or more kinds.

For obtaining the alkenyl complex of platinum, a monofunctional vinyl compound may be used in addition to the components described above. Examples of the monofunctional vinyl compound include trimethoxyvinylsilane, triethoxyvinylsilane, vinylmethyldimethoxysilane and the like.

Regarding the reaction product of the chloroplatinic acid hexahydrate and the alkenyl compound of 6 equivalents having two or more functionalities, the platinum element and the alkenyl compound of 6 equivalents having two or more functionalities are covalently bonded, coordinated, or covalently bonded and coordinated.

In the encapsulant, the content of the catalyst for hydrosilylation reaction is preferably 0.01 ppm or more and 1000 ppm or less in terms of the weight unit of the metal atom (platinum atom in the case of an alkenyl complex of platinum). When the content of the catalyst for hydrosilylation reaction is 0.01 ppm or more, it is easy to sufficiently cure the encapsulant. When the content of the catalyst for hydrosilylation reaction is 1000 ppm or less, the problem of coloring of a cured product is hard to occur. The content of the catalyst for hydrosilylation reaction is more preferably 1 ppm or more and more preferably 500 ppm or less.

(Silicon oxide particles)

The encapsulant for optical semiconductor devices according to the present invention preferably includes silicon oxide particles. By use of the silicon oxide particles, the viscosity of the encapsulant before curing can be adjusted to fall within an appropriate range without impairing the heat resistance and light resistance of a cured product of the encapsulant. Therefore, the handling property of the encapsulant can be enhanced. The silicon oxide particles are preferably surface-treated with an organic silicon compound. Owing to this surface treatment, the dispersibility of the silicon oxide particles is extremely enhanced, and a reduction in viscosity by elevation of the temperature of the encapsulant before curing can be further suppressed.

The primary particle diameter of the silicon oxide particles is preferably 5 nm or more, more preferably 8 nm or more, and preferably 200 nm or less, more preferably 150 nm or less. When the primary particle diameter of the silicon oxide particles is not less than the above-described lower limit, the dispersibility of the silicon oxide particles is further enhanced, and the transparency of the cured product of the encapsulant is further enhanced. When the primary particle diameter of the silicon oxide particles is not more than the above-described upper limit, an effect of increasing the viscosity at 25°C can be adequately obtained, and a reduction in viscosity in the elevation of the temperature can be suppressed.

The primary particle diameter of the silicon oxide particles is measured in the following manner. The cured product of the encapsulant for optical semiconductor devices is observed using a transmission electron microscope (trade name "JEM-2100", manufactured by JEOL Ltd.). The sizes of primary particles of 100 silicon oxide particles in the visual field are each measured, and the average value of measured values is designated as a primary particle diameter. The primary particle diameter refers to an average value of diameters of silicon oxide particles when the silicon oxide particle is spherical, and refers to an average value of longitudinal diameters of silicon oxide particles when the silicon oxide particle is nonspherical.

The BET specific surface area of the silicon oxide particles is preferably 30 $m^2$/g or more and preferably 400 $m^2$/g or less. When the BET specific surface area of the silicon oxide particles is 30 $m^2$/g or more, the viscosity of the encapsulant at 25°C can be controlled to fall within a suitable range, and a reduction in viscosity during temperature elevation can be suppressed. When the BET specific surface area of the silicon oxide particles is 400 $m^2$/g or less, aggregation of the silicon oxide particles is hard to occur, so that dispersibility thereof can be enhanced, and the transparency of the cured product of the encapsulant can be further enhanced.

The silicon oxide particle is not particularly limited, and examples thereof include silica produced by a dry method, such as fumed silica and fused silica, and silica produced by a wet method, such as colloidal silica, sol-gel silica and precipitated silica, and the like. Particularly, fumed silica is suitably used as the silicon oxide particle from the viewpoint of obtaining an encapsulant having a reduced volatile component and having further high transparency.

Examples of the fumed silica include Aerosil 50 (specific surface area: 50 $m^2$/g), Aerosil 90 (specific surface area: 90 $m^2$/g), Aerosil 130 (specific surface area: 130 $m^2$/g), Aerosil 200 (specific surface area: 200 $m^2$/g), Aerosil 300 (specific surface area: 300 $m^2$/g), Aerosil 380 (specific surface area: 380 $m^2$/g) (all of which are manufactured by Nippon Aerosil Co., Ltd.) and the like.

The organic silicon compound is not particularly limited, and examples thereof include a silane-based compound having an alkyl group, a silicon-based compound having a siloxane backbone, such as dimethylsiloxane, a silicon-based

compound having an amino group, a silicon-based compound having a (meth) acryloyl group, a silicon-based compound having an epoxy group, and the like. The " (meth) acryloyl group" refers to an acryloyl group and a methacryloyl group.

The organic silicon compound is preferably at least one selected from the group consisting of an organic silicon compound having a dimethylsilyl group, an organic silicon compound having a trimethylsilyl group and an organic silicon compound having a polydimethylsiloxane group, from the viewpoint of further enhancing the dispersibility of silicon oxide particles.

One example of the method for surface treatment with an organic silicon compound is a method of surface-treating silicon oxide particles using, for example, dichlorodimethylsilane, dimethyldimethoxy silane, hexamethyldisilazane, trimethylsilyl chloride, trimethylmethoxysilane and the like when an organic silicon compound having a dimethylsilyl group or an organic silicon compound having a trimethylsilyl group is used. When an organic silicon compound having a polydimethylsiloxane group is used, mention is made of a method of surface-treating silicon oxide particles using a compound having a silanol group at the terminal of a polydimethylsiloxane group, a cyclic siloxane and the like.

Examples of a commercial product of silicon oxide particles surface-treated with the organic silicon compound having a dimethylsilyl group include R974 (specific surface area: 170 $m^2/g$), R964 (specific surface area: 250 $m^2/g$) (both of which are manufactured by Nippon Aerosil Co., Ltd.) and the like.

Examples of a commercial product of silicon oxide particles surface-treated with the organic silicon compound having a trimethylsilyl group include RX200 (specific surface area: 140 $m^2/g$), R8200 (specific surface area: 140 $m^2/g$) (both of which are manufactured by Nippon Aerosil Co., Ltd.) and the like.

Examples of a commercial product of silicon oxide particles surface-treated with the organic silicon compound having a polydimethylsiloxane group include RY200 (specific surface area: 120 $m^2/g$) and the like.

The method for surface-treating silicon oxide particles with the organic silicon compound is not particularly limited. Examples of the method include direct treatment methods such as a dry method in which silicon oxide particles are added into a mixer, and an organic silicon compound is added with stirring; a slurry method in which an organic silicon compound is added into a slurry of silicon oxide particles; and a spray method in which an organic silicon compound is sprayed after silicon oxide particles are dried; and the like. Examples of a mixer used in the dry method include a Henschel mixer, a V-type mixer and the like. In the dry method, the organic silicon compound is added directly or as an aqueous alcoholic solution, an organic solvent solution or an aqueous solution.

For obtaining silicon oxide particles surface-treated with the organic silicon compound, an integral blend method or the like may be used in which an organic silicon compound is added directly at the time of mixing silicon oxide particles and a matrix resin of the first and second organopolysiloxanes and the like when an encapsulant for optical semiconductor devices is prepared.

The content of the silicon oxide particles is preferably 0.1 part by weight or more, more preferably 0.5 parts by weight or more, and preferably 40 parts by weight or less, more preferably 35 parts by weight or less, further preferably 20 parts by weight or less based on 100 parts by weight of the total of the first organopolysiloxane and the second organopolysiloxane. When the content of the silicon oxide particles is not less than the above-described lower limit, a reduction in viscosity at the time of curing can be suppressed. When the content of the silicon oxide particles is not more than the above-described upper limit, the viscosity of the encapsulant can be controlled to fall within a further appropriate range, and the transparency of the encapsulant can be further enhanced.

(Fluorescent substance)

The encapsulant for optical semiconductor devices according to the present invention may further contain a fluorescent substance. The encapsulant for optical semiconductor devices according to the present invention may not contain a fluorescent substance. In this case, a fluorescent substance can be added to the encapsulant when the encapsulant is used. When a fluorescent substance is added to the encapsulant, the added fluorescent substance is hard to be settled.

The fluorescent substance acts so that light of a desired color can be ultimately obtained by absorbing light emitted from a light emitting element encapsulated using an encapsulant for optical semiconductor devices, and emitting fluorescence. The fluorescent substance is excited by light emitted from the light emitting element to emit fluorescence, and light of a desired color can be obtained by combination of light emitted from the light emitting element and fluorescence emitted from the fluorescent substance.

For example, when it is desired to ultimately obtain white light using an ultraviolet-ray LED chip as a light emitting element, combined use of a blue fluorescent substance, a red fluorescent substance and a green fluorescent substance is preferred. When it is desired to ultimately obtain white light using a blue LED chip as a light emitting element, combined use of a green fluorescent substance and a red fluorescent substance, or use of a yellow fluorescent substance is preferred. The fluorescent substance may be used alone, or in combination of two or more kinds.

The blue fluorescent substance is not particularly limited, and examples thereof include $(Sr, Ca, Ba, Mg)_{10}(PO_4)_6Cl_2$ : Eu, $(Ba, Sr)MgAl_{10}O_{17}$ : Eu, $(Sr, Ba)_3MgSi_2O_8$ : Eu and the like.

The red fluorescent substance is not particularly limited, and examples thereof include (Sr, Ca)S : Eu, (Ca, $Sr)_2Si_5N_8$ : Eu, $CaSiN_2$ : Eu, $CaAlSiN_3$ : Eu, $Y_2O_2S$ : Eu, $La_2O_2S$ : Eu, $LiW_2O_8$ : (Eu, Sm), (Sr, Ca, Bs, $Mg)_{10}(PO_4)_8Cl_2$ : (Eu, Mn), $Ba_3MgSi_2O_8$ : (Eu, Mn) and the like.

The green fluorescent substance is not particularly limited, and examples thereof include $Y_3(Al, Ga)_5O_{12}$ : Ce, $SrGa_2S_4$ : Eu, $Ca_3Sc_2Si_3O_{12}$ : Ce, SrSiON : Eu, ZnS : (Cu, Al), $BaMgAl_{10}O_{17}$(Eu, Mn), $SrAl_2O_4$ : Eu and the like.

The yellow fluorescent substance is not particularly limited, and examples thereof include $Y_3Al_5O_{12}$ : Ce, (Y, $Gd)_3Al_5O_{12}$ : Ce, $Tb_3Al_5O_{12}$ : Ce, $CaGa_2S_4$ : Eu, $Sr_2SiO_4$ : Eu, and the like.

Further, examples of the fluorescent substance include a perylene-based compound that is an organic fluorescent substance and the like.

The content of the fluorescent substance can be appropriately adjusted so as to obtain a desired color, and is not particularly limited. The content of the fluorescent substance is preferably 0.1 parts by weight or more and 40 parts by weight or less based on 100 parts by weight of the encapsulant for optical semiconductor devices according to the present invention. The content of the fluorescent substance is preferably 0.1 parts by weight or more and 40 parts by weight or less based on 100 parts by weight of all components of the encapsulant for optical semiconductor devices except the fluorescent substance.

(Coupling agent)

The encapsulant for optical semiconductor devices according to the present invention may further contain a coupling agent for imparting adhesiveness.

The coupling agent is not particularly limited, and examples thereof include a silane coupling agent and the like. Examples of the silane coupling agent include vinyltriethoxysilane, vinyltrimethoxysilane, 3-glycidoxypropyltrimethoxysilane, 2-(3,4-epoxycyclohexyl)ethyltrimethoxysilane, γ-methacryloxypropyltrimethoxysilane, γ-aminopropyltrimethoxysilane, N-phenyl-3-aminopropyltrimethoxysilane and the like. The coupling agent may be used alone, or in combination of two or more kinds.

(Other components)

The encapsulant for optical semiconductor devices according to the present invention may further contain an additive such as a dispersant, an antioxidant, an antifoaming agent, a coloring agent, a modifier, a leveling agent, a light diffusing agent, a heat conductive filler, a flame retardant or the like as necessary.

Liquids containing one or more of the first organopolysiloxane, the second organopolysiloxane and the catalyst for hydrosilylation reaction may be prepared respectively, and the liquids may be mixed just before use to prepare the encapsulant for optical semiconductor devices according to the present invention. For example, a liquid A containing the first organopolysiloxane and the catalyst for hydrosilylation reaction and a liquid B containing the second organopolysiloxane may be prepared respectively, and the liquids A and B may be mixed just before use to prepare the encapsulant for optical semiconductor devices according to the present invention. In this case, the silicon oxide particles and the fluorescent substance may be each added to the liquid A, or may be each added to the liquid B. As described above, by forming the first organopolysiloxane and the catalyst for hydrosilylation reaction, and the second organopolysiloxane into two liquids: a first liquid and a second liquid, respectively, the storage stability of the encapsulant can be improved.

(Details and applications of encapsulant for optical semiconductor devices)

The curing temperature of the encapsulant for optical semiconductor devices according to the present invention is not particularly limited. The curing temperature of the encapsulant for optical semiconductor devices is preferably 80°C or higher, more preferably 100°C or higher, and preferably 180°C or lower, more preferably 150°C or lower. When the curing temperature is not lower than the above-described lower limit, curing of the encapsulant sufficiently proceeds. When the curing temperature is not higher than the above-described upper limit, heat degradation of the package is hard to occur.

A curing manner is not particularly limited, but a step-cure manner is preferably used. The step-cure manner is a method in which the encapsulant is pre-cured at a low temperature on a temporary basis, and thereafter cured at a high temperature. By use of the step-cure manner, cure shrinkage of the encapsulant can be suppressed.

A method for production of the encapsulant for optical semiconductor devices according to the present invention is not particularly limited, and examples thereof include a method in which the first organopolysiloxane, the second organopolysiloxane, the catalyst for hydrosilylation reaction, and other components that are blended as necessary are mixed at ordinary temperature or under heating using a mixer such as a homodisper, a homomixer, a universal mixer, a planetarium mixer, a kneader, a three-roll mill, a bead mill and the like.

The light emitting element is not particularly limited as long as it is a light emitting element using a semiconductor.

For example when the light emitting element is a light emitting diode, examples thereof include a structure in which a semiconductor material for formation of a LED is stacked on a substrate. In this case, examples of the semiconductor material include GaAs, GaP, GaAlAs, GaAsP, AlGaInP, GaN, InN, AlN, InGaAlN, SiC and the like.

Examples of the material of the substrate include sapphire, spinel, SiC, Si, ZnO, GaN single crystals and the like. A buffer layer may be formed between the substrate and the semiconductor material as necessary. Examples of the material of the buffer layer include GaN, AlN and the like.

Specific examples of the optical semiconductor device according to the present invention include a light emitting diode device, a semiconductor laser device, a photocoupler and the like. These optical semiconductor devices can be suitably used for, for example, light sources for backlights of liquid crystal display panels and the like, illuminators, various kinds of sensors, printers, copiers and the like; light sources for vehicle instruments, signal lamps, indicator lamps, indicators and sheet-like light emitters; displays, ornaments, various kinds of lights, switching elements and the like.

In the optical semiconductor device according to the present invention, the light emitting element formed of an optical semiconductor is encapsulated by the encapsulant for optical semiconductor devices according to the present invention. In the optical semiconductor device according to the present invention, the cured product of the encapsulant for optical semiconductor devices is placed so as to encapsulate the light emitting element formed of an optical semiconductor such as an LED. Therefore, cracking is hard to occur in the cured product of the encapsulant for optical semiconductor devices, which encapsulates the light emitting element, detachment from the package is hard to occur, and the light permeability, heat resistance, weathering resistance and the gas barrier property can be enhanced.

(Embodiment of optical semiconductor device)

Fig. 1 is a front sectional view showing an optical semiconductor device according to one embodiment of the present invention.

An optical semiconductor device 1 of this embodiment has a housing 2. An optical semiconductor element 3 formed of an LED is mounted in the housing 2. An inner surface 2a of the housing 2, which has a light reflecting property, surrounds the periphery of the optical semiconductor element 3. In this embodiment, the optical semiconductor element 3 is used as a light emitting element formed of an optical semiconductor.

The inner surface 2a is formed such that the diameter of the inner surface 2a becomes larger gradually toward an open end. Therefore, of light emitted from the optical semiconductor element 3, light arriving at the inner surface 2a is reflected by the inner surface 2a, and travels to the front side of the optical semiconductor element 3. A region surrounded by the inner surface 2a is filled therein with an encapsulant 4 for optical semiconductor devices so as to encapsulate the optical semiconductor element 3.

The structure shown in Fig. 1 is only one example of the optical semiconductor device according to the present invention, and the mount structure and the like of the optical semiconductor device can be appropriately modified.

The present invention will be described more in detail below by way of examples. The present invention is not limited to the examples below.

(Synthesis Example 1) Synthesis of first organopolysiloxane represented by formula (1A)

Into a 1000 mL separable flask equipped with a thermometer, a dropping device and a stirrer were added 476 g of dimethyldimethoxysilane and 5.3 g of 1,3-divinyl-1,1,3,3-tetramethyldisiloxane, and the mixture was stirred at 50°C. A solution obtained by dissolving 2.2 g of potassium hydroxide in 144 g of water was slowly added dropwise therein, and thereafter the mixture was stirred at 50°C for 6 hours and reacted to obtain a reaction liquid. Next, the pressure was reduced to remove volatile components, 2.4 g of acetic acid was added to the reaction liquid, and the mixture was heated under reduced pressure. Thereafter, potassium acetate was removed by filtration to obtain a polymer (A).

The number average molecular weight of the obtained polymer (A) was 5830. The chemical structure was identified by $^{29}$Si-NMR, and resultantly it was found that the polymer (A) had the following average composition formula (A1).

$$(Me_2SiO_{2/2})_{0.98}\ (ViMe_2SiO_{1/2})_{0.022} \qquad \text{formula (A1)}$$

In the above formula (A1), Me represents a methyl group, and Vi represents a vinyl group. In the obtained polymer (A), the content ratio of methyl groups was 98.9 mol%, and the content ratio of vinyl groups was 1.1 mol%.

The molecular weight of each polymer obtained in Synthesis Example 1 and Synthesis Examples 2 to 11 was determined by adding 1 mL of tetrahydrofuran to 10 mg of the polymer, stirring the mixture until the polymer was dissolved, and subjecting the solution to GPC measurement. In the GPC measurement, a measuring apparatus manufactured by Waters Corporation (column: two pieces of Shodex GPC LF-804 (length: 300 mm) manufactured by SHOWA DENKO K.K.; measurement temperature: 40°C; flow rate: 1 mL/minute; solvent: tetrahydrofuran; standard substance: polystyrene) was used.

(Synthesis Example 2) Synthesis of first organopolysiloxane represented by formula (1A)

Into a 1000 mL separable flask equipped with a thermometer, a dropping device and a stirrer were added 486 g of dimethyldimethoxysilane and 2.7 g of 1,3-divinyl-1,1,3,3-tetramethyldisiloxane, and the mixture was stirred at 50°C. A solution obtained by dissolving 2.2 g of potassium hydroxide in 144 g of water was slowly added dropwise therein, and thereafter the mixture was stirred at 50°C for 6 hours and reacted to obtain a reaction liquid. Next, the pressure was reduced to remove volatile components, 2.4 g of acetic acid was added to the reaction liquid, and the mixture was heated under reduced pressure. Thereafter, potassium acetate was removed by filtration to obtain a polymer (B).
The number average molecular weight of the obtained polymer (B) was 37400. The chemical structure was identified by $^{29}$Si-NMR, and resultantly it was found that the polymer (B) had the following average composition formula (B1).

$$(Me_2SiO_{2/2})_{0.992}\ (ViMe_2SiO_{1/2})_{0.008} \qquad \text{formula (B1)}$$

In the above formula (B1), Me represents a methyl group, and Vi represents a vinyl group. In the obtained polymer (B), the content ratio of methyl groups was 99.6 mol%, and the content ratio of vinyl groups was 0.4 mol%.

(Synthesis Example 3) Synthesis of first organopolysiloxane represented by formula (1A)

Into a 1000 mL separable flask equipped with a thermometer, a dropping device and a stirrer were added 488 g of dimethyldimethoxysilane and 1.2 g of 1,3-divinyl-1,1,3,3-tetramethyldisiloxane, and the mixture was stirred at 50°C. A solution obtained by dissolving 2.2 g of potassium hydroxide in 144 g of water was slowly added dropwise therein, and thereafter the mixture was stirred at 50°C for 6 hours and reacted to obtain a reaction liquid. Next, the pressure was reduced to remove volatile components, 2.4 g of acetic acid was added to the reaction liquid, and the mixture was heated under reduced pressure. Thereafter, potassium acetate was removed by filtration to obtain a polymer (C).
The number average molecular weight of the obtained polymer (C) was 82800. The chemical structure was identified by $^{29}$Si-NMR, and resultantly it was found that the polymer (C) had the following average composition formula (C1).

$$(Me_2SiO_{2/2})_{0.998}\ (ViMe_2SiO_{1/2})_{0.002} \qquad \text{formula (C1)}$$

In the above formula (C1), Me represents a methyl group, and Vi represents a vinyl group. In the obtained polymer (C), the content ratio of methyl groups was 99.9 mol%, and the content ratio of vinyl groups was 0.1 mol%.

(Synthesis Example 4) Synthesis of first organopolysiloxane represented by formula (1A) or second organopolysiloxane represented by formula (51B)

Into a 1000 mL separable flask equipped with a thermometer, a dropping device and a stirrer were added 298 g of dimethyldimethoxysilane, 17 g of methyltrimethoxysilane, 31 g of vinyltrimethoxysilane and 40 g of 1,1,3,3-tetramethyldisiloxane, and the mixture was stirred at 50°C. A solution of 2.0 g of hydrochloric acid and 134 g of water was slowly added dropwise therein, and thereafter the mixture was stirred at 50°C for 6 hours and reacted to obtain a reaction liquid. Next, the pressure was reduced to remove volatile components, so that a polymer was obtained. To the obtained polymer were added 150 g of hexane and 150 g of ethyl acetate, the mixture was washed with 300 g of ion-exchanged water 10 times, and the pressure was reduced to remove volatile components, so that a polymer (D) was obtained.
The number average molecular weight of the obtained polymer (D) was 9530. The chemical structure was identified by $^{29}$Si-NMR, and resultantly it was found that the polymer (D) had the following average composition formula (D1).

$$(Me_2SiO_{2/2})_{0.81}(MeSiO_{3/2})_{0.03}(ViSiO_{3/2})_{0.07}(HMe_2SiO_{1/2})_{0.09} \qquad \text{formula (D1)}$$

In the above formula (D1), Me represents a methyl group, and Vi represents a vinyl group. In the obtained polymer (D), the content ratio of methyl groups was 92.0 mol%, the content ratio of vinyl groups was 3.5 mol%, and the content ratio of hydrogen atoms bonded to silicon atoms was 4.5 mol%.

(Synthesis Example 5) Synthesis of first organopolysiloxane represented by formula (1B) or second organopolysiloxane represented by formula (51A)

Into a 1000 mL separable flask equipped with a thermometer, a dropping device and a stirrer were added 90.2 g of dimethyldimethoxysilane, 217 g of methyltrimethoxysilane, 31 g of vinyltrimethoxysilane, 40 g of 1,1,3,3-tetramethyldisiloxane and 16 g of trimethylmethoxysilane, and the mixture was stirred at 50°C. A solution of 2.0 g of hydrochloric acid and 134 g of water was slowly added dropwise therein, and thereafter the mixture was stirred at 50°C for 6 hours and reacted to obtain a reaction liquid. Next, the pressure was reduced to remove volatile components, so that a polymer was obtained. To the obtained polymer were added 150 g of hexane and 150 g of ethyl acetate, the mixture was washed with 300 g of ion-exchanged water 10 times, and the pressure was reduced to remove volatile components, so that a polymer (E) was obtained.

The number average molecular weight of the obtained polymer (E) was 3420. The chemical structure was identified by $^{29}$Si-NMR, and resultantly it was found that the polymer (E) had the following average composition formula (E1).

$$(Me_2SiO_{2/2})_{0.25}(MeSiO_{3/2})_{0.52}(ViSiO_{3/2})_{0.07}(HMe_2SiO_{1/2})_{0.10}(Me_3\ SiO_{1/2})_{0.06} \quad \text{formula (E1)}$$

In the above formula (E1), Me represents a methyl group, and Vi represents a vinyl group.

In the obtained polymer (E), the content ratio of methyl groups was 89.1 mol%, the content ratio of vinyl groups was 4.5 mol%, and the content ratio of hydrogen atoms bonded to silicon atoms was 6.4 mol%.

(Synthesis Example 6) Synthesis of first organopolysiloxane represented by formula (1B) or second organopolysiloxane represented by formula (51A)

Into a 1000 mL separable flask equipped with a thermometer, a dropping device and a stirrer were added 54 g of 1,1,3,3-tetramethyldisiloxane, 37 g of vinyltrimethoxysilane, 343 g of methyltrimethoxysilane and 84 g of trimethylmethoxysilane, and the mixture was stirred at 50°C. A solution of 2.0 g of hydrochloric acid and 134 g of water was slowly added dropwise therein, and thereafter the mixture was stirred at 50°C for 6 hours and reacted to obtain a reaction liquid. Next, the pressure was reduced to remove volatile components, so that a polymer was obtained. To the obtained polymer were added 150 g of hexane and 150 g of ethyl acetate, the mixture was washed with 300 g of ion-exchanged water 10 times, and the pressure was reduced to remove volatile components, so that a polymer (F) was obtained.

The number average molecular weight of the obtained polymer (F) was 2320. The chemical structure was identified by $^{29}$Si-NMR, and resultantly it was found that the polymer (F) had the following average composition formula (F1).

$$(HMe_2SiO_{1/2})_{0.09}(Me_3SiO_{1/2})_{0.21}(ViSiO_{3/2})_{0.07}(MeSiO_{3/2})_{0.63} \quad \text{formula (F1)}$$

In the above formula (F1), Me represents a methyl group, and Vi represents a vinyl group. In the obtained polymer (F), the content ratio of methyl groups was 90.0 mol%, the content ratio of vinyl groups was 4.4 mol%, and the content ratio of hydrogen atoms bonded to silicon atoms was 5.6 mol%.

(Synthesis Example 7) Synthesis of second organopolysiloxane represented by formula (51B)

Into a 1000 mL separable flask equipped with a thermometer, a dropping device and a stirrer were added 470 g of dimethyldimethoxysilane and 12 g of 1,1,3,3-tetramethyldisiloxane, and the mixture was stirred at 50°C. A solution obtained by dissolving 2.0 g of hydrochloric acid in 134 g of water was slowly added dropwise therein, and thereafter the mixture was stirred at 50°C for 6 hours and reacted to obtain a reaction liquid. To the obtained polymer were added 150 g of hexane and 150 g of ethyl acetate, the mixture was washed with 300 g of ion-exchanged water 10 times, and the pressure was reduced to remove volatile components, so that a polymer (G) was obtained.

The number average molecular weight of the obtained polymer (G) was 5230. The chemical structure was identified by $^{29}$Si-NMR, and resultantly it was found that the polymer (G) had the following average composition formula (G1).

$$(Me_2SiO_{2/2})_{0.97}(HMeSiO_{1/2})_{0.024} \quad \text{formula (G1)}$$

In the above formula (G1), Me represents a methyl group. In the obtained polymer (G), the content ratio of methyl groups was 98.8 mol%, and the content ratio of hydrogen atoms bonded to silicon atoms was 1.2 mol%.

(Synthesis Example 8) Synthesis of second organopolysiloxane represented by formula (51B)

Into a 1000 mL separable flask equipped with a thermometer, a dropping device and a stirrer were added 476 g of dimethyldimethoxysilane and 5.4 g of 1,1,3,3-tetramethyldisiloxane, and the mixture was stirred at 50°C. A solution obtained by dissolving 2.0 g of hydrochloric acid in 134 g of water was slowly added dropwise therein, and thereafter the mixture was stirred at 50°C for 6 hours and reacted to obtain a reaction liquid. To the obtained polymer were added 150 g of hexane and 150 g of ethyl acetate, the mixture was washed with 300 g of ion-exchanged water 10 times, and the pressure was reduced to remove volatile components, so that a polymer (H) was obtained.
The number average molecular weight of the obtained polymer (H) was 35300. The chemical structure was identified by $^{29}$Si-NMR, and resultantly it was found that the polymer (H) had the following average composition formula (H1).

$$(Me_2SiO_{2/2})_{0.992}(HMeSiO_{1/2})_{0.008} \qquad \text{formula (H1)}$$

In the above formula (H1), Me represents a methyl group. In the obtained polymer (H), the content ratio of methyl groups was 99.6 mol%, and the content ratio of hydrogen atoms bonded to silicon atoms was 0.4 mol%.

(Synthesis Example 9) Synthesis of second organopolysiloxane represented by formula (51B)

Into a 1000 mL separable flask equipped with a thermometer, a dropping device and a stirrer were added 480 g of dimethyldimethoxysilane and 1.6 g of 1,1,3,3-tetramethyldisiloxane, and the mixture was stirred at 50°C. A solution obtained by dissolving 2.0 g of hydrochloric acid in 134 g of water was slowly added dropwise therein, and thereafter the mixture was stirred at 50°C for 6 hours and reacted to obtain a reaction liquid. To the obtained polymer were added 150 g of hexane and 150 g of ethyl acetate, the mixture was washed with 300 g of ion-exchanged water 10 times, and the pressure was reduced to remove volatile components, so that a polymer (I) was obtained.
The number average molecular weight of the obtained polymer (I) was 78200. The chemical structure was identified by $^{29}$Si-NMR, and resultantly it was found that the polymer (I) had the following average composition formula (I1).

$$(Me_2SiO_{2/2})_{0.998}(HMeSiO_{1/2})_{0.002} \qquad \text{formula (I1)}$$

In the above formula (I1), Me represents a methyl group. In the obtained polymer (I), the content ratio of methyl groups was 99.9 mol%, and the content ratio of hydrogen atoms bonded to silicon atoms was 0.1 mol%.

(Synthesis Example 10) Synthesis of first organopolysiloxane represented by formula (1B) or second organopolysiloxane represented by formula (51A)

Into a 1000 mL separable flask equipped with a thermometer, a dropping device and a stirrer were added 90.2 g of dimethyldimethoxysilane, 217 g of methyltrimethoxysilane, 31 g of vinyltrimethoxysilane, 32 g of 1,1,3,3-tetramethyldisiloxane and 19 g of trimethylmethoxysilane, and the mixture was stirred at 50°C. A solution of 2.0 g of hydrochloric acid and 134 g of water was slowly added dropwise therein, and thereafter the mixture was stirred at 50°C for 6 hours and reacted to obtain a reaction liquid. Next, the pressure was reduced to remove volatile components, so that a polymer was obtained. To the obtained polymer were added 150 g of hexane and 150 g of ethyl acetate, the mixture was washed with 300 g of ion-exchanged water 10 times, and the pressure was reduced to remove volatile components, so that a polymer (J) was obtained.
The number average molecular weight of the obtained polymer (J) was 3320. The chemical structure was identified by $^{29}$Si-NMR, and resultantly it was found that the polymer (J) had the following average composition formula (J1).

$$(Me_2SiO_{2/2})_{0.25}(MeSiO_{3/2})_{0.52}(ViSiO_{3/2})_{0.07}(HMe_2SiO_{1/2})_{0.08}(Me_3\ SiO_{1/2})_{0.08} \qquad \text{formula (J1)}$$

In the above formula (J1), Me represents a methyl group, and Vi represents a vinyl group. In the obtained polymer (J), the content ratio of methyl groups was 90.4 mol%, the content ratio of vinyl groups was 4.5 mol%, and the content ratio of hydrogen atoms bonded to silicon atoms was 5.1 mol%.

(Synthesis Example 11) Synthesis of first organopolysiloxane represented by formula (1B) or second organopolysiloxane represented by formula (51A)

Into a 1000 mL separable flask equipped with a thermometer, a dropping device and a stirrer were added 90.2

g of dimethyldimethoxysilane, 217 g of methyltrimethoxysilane, 31 g of vinyltrimethoxysilane, 24 g of 1,1,3,3-tetramethyldisiloxane and 25 g of trimethylmethoxysilane, and the mixture was stirred at 50°C. A solution of 2.0 g of hydrochloric acid and 134 g of water was slowly added dropwise therein, and thereafter the mixture was stirred at 50°C for 6 hours and reacted to obtain a reaction liquid. Next, the pressure was reduced to remove volatile components, so that a polymer was obtained. To the obtained polymer were added 150 g of hexane and 150 g of ethyl acetate, the mixture was washed with 300 g of ion-exchanged water 10 times, and the pressure was reduced to remove volatile components, so that a polymer (K) was obtained.

The number average molecular weight of the obtained polymer (K) was 3300. The chemical structure was identified by $^{29}$Si-NMR, and resultantly it was found that the polymer (K) had the following average composition formula (K1).

$$(Me_2SiO_{2/2})_{0.25}(MeSiO_{3/2})_{0.52}(ViSiO_{3/2})_{0.07}(HMe_2SiO_{1/2})_{0.06}(Me_3\ SiO_{1/2})_{0.10} \quad \text{formula (K1)}$$

In the above formula (K1), Me represents a methyl group, and Vi represents a vinyl group. In the obtained polymer (K), the content ratio of methyl groups was 91.7 mol%, the content ratio of vinyl groups was 4.5 mol%, and the content ratio of hydrogen atoms bonded to silicon atoms was 3.8 mol%.

(Example 1)

The polymer B (10 g), the polymer E (10 g) and a 1,3-divinyl-1,1,3,3-tetramethyldisiloxane complex of platinum (in such an amount that the content of the platinum metal was 10 ppm in terms of a weight based on the total amount of the encapsulant) were mixed, and the mixture was degassed to obtain an encapsulant for optical semiconductor devices.

(Example 2)

The polymer B (10 g), the polymer F (10 g) and a 1,3-divinyl-1,1,3,3-tetramethyldisiloxane complex of platinum (in such an amount that the content of the platinum metal was 10 ppm in terms of a weight based on the total amount of the encapsulant) were mixed, and the mixture was degassed to obtain an encapsulant for optical semiconductor devices.

(Example 3)

The polymer C (10 g), the polymer E (10 g) and a 1,3-divinyl-1,1,3,3-tetramethyldisiloxane complex of platinum (in such an amount that the content of the platinum metal was 10 ppm in terms of a weight based on the total amount of the encapsulant) were mixed, and the mixture was degassed to obtain an encapsulant for optical semiconductor devices.

(Example 4)

The polymer C (10 g), the polymer F (10 g) and a 1,3-divinyl-1,1,3,3-tetramethyldisiloxane complex of platinum (in such an amount that the content of the platinum metal was 10 ppm in terms of a weight based on the total amount of the encapsulant) were mixed, and the mixture was degassed to obtain an encapsulant for optical semiconductor devices.

(Example 5)

The polymer A (10 g), the polymer E (10 g) and a 1,3-divinyl-1,1,3,3-tetramethyldisiloxane complex of platinum (in such an amount that the content of the platinum metal was 10 ppm in terms of a weight based on the total amount of the encapsulant) were mixed, and the mixture was degassed to obtain an encapsulant for optical semiconductor devices.

(Example 6)

The polymer H (10 g), the polymer E (10 g) and a 1,3-divinyl-1,1,3,3-tetramethyldisiloxane complex of platinum (in such an amount that the content of the platinum metal was 10 ppm in terms of a weight based on the total amount of the encapsulant) were mixed, and the mixture was degassed to obtain an encapsulant for optical semiconductor devices.

(Example 7)

The polymer H (10 g), the polymer F (10 g) and a 1,3-divinyl-1,1,3,3-tetramethyldisiloxane complex of platinum (in such an amount that the content of the platinum metal was 10 ppm in terms of a weight based on the total amount of the encapsulant) were mixed, and the mixture was degassed to obtain an encapsulant for optical semiconductor devices.

(Example 8)

The polymer I (10 g), the polymer E (10 g) and a 1,3-divinyl-1,1,3,3-tetramethyldisiloxane complex of platinum (in such an amount that the content of the platinum metal was 10 ppm in terms of a weight based on the total amount of the encapsulant) were mixed, and the mixture was degassed to obtain an encapsulant for optical semiconductor devices.

(Example 9)

The polymer I (10 g), the polymer F (10 g) and a 1,3-divinyl-1,1,3,3-tetramethyldisiloxane complex of platinum (in such an amount that the content of the platinum metal was 10 ppm in terms of a weight based on the total amount of the encapsulant) were mixed, and the mixture was degassed to obtain an encapsulant for optical semiconductor devices.

(Example 10)

The polymer G (10 g), the polymer E (10 g) and a 1,3-divinyl-1,1,3,3-tetramethyldisiloxane complex of platinum (in such an amount that the content of the platinum metal was 10 ppm in terms of a weight based on the total amount of the encapsulant) were mixed, and the mixture was degassed to obtain an encapsulant for optical semiconductor devices.

(Example 11)

The polymer B (10 g), the polymer J (10 g) and a 1,3-divinyl-1,1,3,3-tetramethyldisiloxane complex of platinum (in such an amount that the content of the platinum metal was 10 ppm in terms of a weight based on the total amount of the encapsulant) were mixed, and the mixture was degassed to obtain an encapsulant for optical semiconductor devices.

(Example 12)

The polymer B (10 g), the polymer K (10 g) and a 1,3-divinyl-1,1,3,3-tetramethyldisiloxane complex of platinum (in such an amount that the content of the platinum metal was 10 ppm in terms of a weight based on the total amount of the encapsulant) were mixed, and the mixture was degassed to obtain an encapsulant for optical semiconductor devices.

(Example 13)

The polymer H (10 g), the polymer K (10 g) and a 1,3-divinyl-1,1,3,3-tetramethyldisiloxane complex of platinum (in such an amount that the content of the platinum metal was 10 ppm in terms of a weight based on the total amount of the encapsulant) were mixed, and the mixture was degassed to obtain an encapsulant for optical semiconductor devices.

(Comparative Example 1)

The polymer A (10 g), the polymer D (10 g) and a 1,3-divinyl-1,1,3,3-tetramethyldisiloxane complex of platinum (in such an amount that the content of the platinum metal was 10 ppm in terms of a weight based on the total amount of the encapsulant) were mixed, and the mixture was degassed to obtain an encapsulant for optical semiconductor devices.

(Comparative Example 2)

The polymer B (10 g), the polymer D (10 g) and a 1,3-divinyl-1,1,3,3-tetramethyldisiloxane complex of platinum (in such an amount that the content of the platinum metal was 10 ppm in terms of a weight based on the total amount of the encapsulant) were mixed, and the mixture was degassed to obtain an encapsulant for optical semiconductor devices.

(Comparative Example 3)

The polymer G (10 g), the polymer D (10 g) and a 1,3-divinyl-1,1,3,3-tetramethyldisiloxane complex of platinum (in such an amount that the content of the platinum metal was 10 ppm in terms of a weight based on the total amount of the encapsulant) were mixed, and the mixture was degassed to obtain an encapsulant for optical semiconductor devices.

(Comparative Example 4)

The polymer H (10 g), the polymer D (10 g) and a 1,3-divinyl-1,1,3,3-tetramethyldisiloxane complex of platinum (in such an amount that the content of the platinum metal was 10 ppm in terms of a weight based on the total amount of the encapsulant) were mixed, and the mixture was degassed to obtain an encapsulant for optical semiconductor devices.

(Evaluation)

(Preparation of optical semiconductor device)

In a structure in which a light emitting element having a main light emission peak of 460 nm is mounted by a die bond material on a housing material made of polyphthalamide, which is provided with a lead electrode plated with silver, and the light emitting element and the lead electrode are connected to each other by a gold wire, the obtained encapsulant for optical semiconductor devices was injected, and cured by heating at 150°C for 2 hours to prepare an optical semiconductor device. This optical semiconductor device was used to conduct the heat shock test described below.

(Heat shock test)

A thermal cycle test having, as one cycle, a process of retaining the obtained optical semiconductor device at -50°C for 5 minutes, followed by elevating the temperature to 135°C, and retaining the optical semiconductor device at 135°C for 5 minutes, followed by lowering the temperature to -50°C was conducted using a liquid bath-type heat shock tester ("TSB-51" manufactured by ESPEC CORP.). Twenty samples were taken out after 1000 cycles, 2000 cycles, 3000 cycles and 4000 cycles respectively.

Samples were observed with a stereoscopic microscope ("SMZ-10" manufactured by NIKON CORPORATION). Observations were made to check whether or not cracking occurred in encapsulants for optical semiconductor devices or whether or not the encapsulant for optical semiconductor devices was detached from the package or the electrode for 20 samples, and the number of samples in which cracking or detachment occurred (NG number) was counted.

(Hardness ratio)

The obtained encapsulant for optical semiconductor devices was heated at 150°C for 2 hours to be cured. A hardness of the cured encapsulant for optical semiconductor devices was measured by a low-pressure load device ("CL-150" manufactured by ASKER CO., LTD.; A type rubber meter), and determined as an initial value of hardness. As a heat degradation test, the cured encapsulant for optical semiconductor devices was placed in an oven at 150°C for 500 hours, and a hardness was then measured by the low-pressure load device ("CL-150" manufactured by ASKER CO., LTD.; A-type rubber hardness tester), and determined as a value of hardness after the heat degradation test. From the initial value of hardness and the value of hardness after the heat degradation test, a hardness ratio (value after heat degradation test/initial value) was calculated.

(Heat resistance test)

The obtained encapsulant for optical semiconductor devices was heated at 150°C for 2 hours to be cured. A transmittance of the cured encapsulant for optical semiconductor devices was measured by a UV-VIS photometer ("U-3000" manufactured by Hitachi, Ltd.), and a value at 400 nm was determined as an initial value. As a heat resistance test, the cured encapsulant for optical semiconductor devices was placed in an oven at 200°C for 500 hours, a transmittance was then measured by the UV-VIS photometer ("U-3000" manufactured by Hitachi, Ltd.), and a retention to the initial value at 400 nm was calculated as a percentage.

(Evaluation of stickiness (tackiness) of surface of cured product of encapsulant)

The obtained optical semiconductor device was left standing under an atmosphere at 23°C and 50 RH% for 24 hours. After the optical semiconductor device was left standing for 24 hours, stickiness (tackiness) of the surface of the cured product of the encapsulant for optical semiconductor devices was checked by touching the cured product with a finger. Stickiness (tackiness) was evaluated in accordance with the following criteria.

[Evaluation criteria of stickiness (tackiness)]

○○: not sticky (tacky) at all.
○: almost not sticky (tacky).
Δ: slightly sticky (tacky).
×: significantly sticky (tacky).

The results are shown in Table 1 below. Values of the above-described ratio (content ratio of hydrogen atoms bonded to silicon atoms / content ratio of alkenyl groups bonded to silicon atoms) are also shown in Table 1 below.

[Table 1]

| | | Ex. 1 | Ex. 2 | Ex. 3 | Ex. 4 | Ex. 5 | Ex. 6 | Ex. 7 | Ex. 8 | Ex. 9 | Ex. 10 |
|---|---|---|---|---|---|---|---|---|---|---|---|
| Ratio (content ratio of hydrogen atoms / content ratio of alkenyl groups) | | 1.31 | 1.17 | 1.39 | 1.24 | 1.14 | 1.51 | 1.36 | 1.44 | 1.30 | 1.69 |
| Heat shock test | 1000 cycles | 0/20 | 0/20 | 0/20 | 0/20 | 0/20 | 0/20 | 0/20 | 0/20 | 0/20 | 0/20 |
| | 2000 cycles | 0/20 | 0/20 | 0/20 | 0/20 | 0/20 | 0/20 | 0/20 | 0/20 | 0/20 | 0/20 |
| | 3000 cycles | 2/20 | 4/20 | 0/20 | 1/20 | 0/20 | 3/20 | 5/20 | 0/20 | 1/20 | 0/20 |
| | 4000 cycles | 5/20 | 8/20 | 2/20 | 3/20 | 0/20 | 11/20 | 14/20 | 5/20 | 8/20 | 5/20 |
| Hardness ratio (value after heat degradation test / initial value) | | 1.1 | 1.1 | 1.1 | 1.1 | 1.0 | 1.2 | 1.2 | 1.1 | 1.1 | 1.2 |
| Transmittance retention [%] after heat resistance test | | 95.5 | 95.2 | 96.6 | 96.1 | 95.3 | 95.0 | 94.8 | 95.8 | 96.2 | 95.8 |
| Stickiness (tackiness) of surface | | ○○ | ○○ | ○ | ○ | Δ | ○○ | ○○ | ○ | ○ | Δ |

| | | Ex. 11 | Ex. 12 | Ex. 13 | Comp.Ex. 1 | Comp.Ex. 2 | Comp.Ex. 3 | Comp.Ex. 4 |
|---|---|---|---|---|---|---|---|---|
| Ratio (content ratio of hydrogen atoms / content ratio of alkenyl groups) | | 1.04 | 0.78 | 0.93 | 0.98 | 1.15 | 1.63 | 1.4 |
| Heat shock test | 1000 cycles | 0/20 | 0/20 | 0/20 | 0/20 | 0/20 | 0/20 | 0/20 |
| | 2000 cycles | 0/20 | 0/20 | 0/20 | 0/20 | 0/20 | 0/20 | 0/20 |
| | 3000 cycles | 0/20 | 0/20 | 0/20 | 0/20 | 0/20 | 0/20 | 0/20 |
| | 4000 cycles | 0/20 | 0/20 | 0/20 | 0/20 | 2/20 | 4/20 | 1/20 |
| Hardness ratio (value after heat degradation test / initial value) | | 1.0 | 1.0 | 1.0 | 1.0 | 1.1 | 1.2 | 1.1 |
| Transmittance retention [%] after heat resistance test | | 96.2 | 90.3 | 95.9 | 95.2 | 94.8 | 95.6 | 95.1 |
| Stickiness (tackiness) of surface | | ○○ | Δ | Δ | × | × | × | × |

## EXPLANATION OF SYMBOLS

1: Optical semiconductor device
2: Housing
2a: Inner surface
3: Optical semiconductor element
4: Encapsulant for optical semiconductor devices

## Claims

**1.** An encapsulant for optical semiconductor devices, which comprises: a first organopolysiloxane having an alkenyl group and a methyl group bonded to a silicon atom;
a second organopolysiloxane having a hydrogen atom bonded to a silicon atom and a methyl group bonded to a silicon atom; and
a catalyst for hydrosilylation reaction, wherein
the first organopolysiloxane is a first organopolysiloxane represented by the following formula (1A) and the second organopolysiloxane is a second organopolysiloxane represented by the following formula (51A), or the first organopolysiloxane is a first organopolysiloxane represented by the following formula (1B) and the second organopolysiloxane is a second organopolysiloxane represented by the following formula (51B), and
the content ratios of methyl groups bonded to silicon atoms in the first organopolysiloxane and the second organopolysiloxane each are 80 mol% or more.

[Formula 1] $\mathbf{(R1R2R3SiO_{1/2})_a\ (R4R5SiO_{2/2})_b(R6SiO_{3/2})_c}$ **Formula (1A)**

In the formula (1A), a, b and c satisfy a / (a + b + c) = 0 to 0.30, b / (a + b + c) = 0.70 to 1.0 and c / (a + b + c) = 0 to 0. 10, at least one of R1 to R6 represents an alkenyl group, at least one of R1 to R6 represents a methyl group, and R1 to R6 other than an alkenyl group and a methyl group represent a hydrocarbon group having 2 to 8 carbon atoms.

[Formula 2] $\mathbf{(R51R52R53SiO_{1/2})_p\ (R54R55SiO_{2/2})_q\ (R56SiO_{3/2})_r}$ **Formula (51A)**

In the formula (51A), p, q and r satisfy p / (p + q + r) = 0.10 to 0.50, q / (p + q + r) = 0 to 0.40 and r / (p + q + r) = 0.40 to 0.90, at least one of R51 to R56 represents a hydrogen atom, at least one of R51 to R56 represents a methyl group, and R51 to R56 other than a hydrogen atom and a methyl group represent a hydrocarbon group having 2 to 8 carbon atoms.

[Formula 3] $\mathbf{(R1R2R3SiO_{1/2})_a\ (R4R5SiO_{2/2})_b(R6SiO_{3/2})_c}$ **Formula (1B)**

In the formula (1B), a, b and c satisfy a / (a + b + c) = 0.10 to 0.50, b / (a + b + c) = 0 to 0.40 and c / (a + b + c) = 0.40 to 0.90, at least one of R1 to R6 represents an alkenyl group, at least one of R1 to R6 represents a methyl group, and R1 to R6 other than an alkenyl group and a methyl group represent a hydrocarbon group having 2 to 8 carbon atoms.

[Formula 4] $\mathbf{(R51R52R53SiO_{1/2})_p\ (R54R55SiO_{2/2})_q\ (R56SiO_{3/2})_r}$ **Formula (51B)**

In the formula (51B), p, q and r satisfy p / (p + q + r) = 0 to 0.30, q / (p + q + r) = 0.70 to 1.0 and r / (p + q + r) = 0 to 0.10, at least one of R51 to R56 represents a hydrogen atom, at least one of R51 to R56 represents a methyl group, and R51 to R56 other than a hydrogen atom and a methyl group represent a hydrocarbon group having 2 to 8 carbon atoms.

**2.** The encapsulant for optical semiconductor devices according to claim 1, wherein a ratio of the content ratio of hydrogen atoms bonded to silicon atoms of the organopolysiloxane in the encapsulant to the content ratio of alkenyl groups bonded to silicon atoms of the organopolysiloxane in the encapsulant is 0.5 or more and 5.0 or less.

**3.** The encapsulant for optical semiconductor devices according to claim 2, wherein a ratio of the content ratio of

hydrogen atoms bonded to silicon atoms of the organopolysiloxane in the encapsulant to the content ratio of alkenyl groups bonded to silicon atoms of the organopolysiloxane in the encapsulant is 0.5 or more and 2.0 or less.

**4.** The encapsulant for optical semiconductor devices according to any one of claims 1 to 3, wherein the first organopolysiloxane is a first organopolysiloxane represented by the formula (1A) and the second organopolysiloxane is a second organopolysiloxane represented by the formula (51A).

**5.** The encapsulant for optical semiconductor devices according to any one of claims 1 to 4, wherein the number average molecular weight of the first organopolysiloxane represented by the formula (1A) is 20000 or more and 100000 or less.

**6.** The encapsulant for optical semiconductor devices according to any one of claims 1 to 5, wherein the second organopolysiloxane represented by the formula (51A) has an alkenyl group.

**7.** The encapsulant for optical semiconductor devices according to any one of claims 1 to 6, wherein the second organopolysiloxane represented by the formula (51A) has a structural unit represented by the following formula (51-a).

[Formula 5]

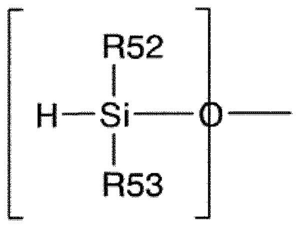

···Formula (51−a)

In the formula (51-a), R52 and R53 each represent a methyl group or a hydrocarbon group having 2 to 8 carbon atoms.

**8.** The encapsulant for optical semiconductor devices according to any one of claims 1 to 3, wherein the first organopolysiloxane is a first organopolysiloxane represented by the formula (1B) and the second organopolysiloxane is a second organopolysiloxane represented by the formula (51B).

**9.** The encapsulant for optical semiconductor devices according to any one of claims 1, 2, 3 and 8, wherein the number average molecular weight of the second organopolysiloxane represented by the formula (51B) is 20000 or more and 100000 or less.

**10.** The encapsulant for optical semiconductor devices according to any one of claims 1, 2, 3, 8 and 9, wherein the first organopolysiloxane of the formula (1B) has a hydrogen atom bonded to a silicon atom.

**11.** The encapsulant for optical semiconductor devices according to any one of claims 1, 2, 3, 8, 9 and 10, wherein the first organopolysiloxane represented by the formula (1B) has a structural unit represented by the following formula (1-b1).

[Formula 6]

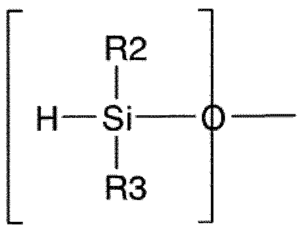

···Formula (1−b1)

In the formula (1-b1), R2 and R3 each represent a methyl group or a hydrocarbon group having 2 to 8 carbon atoms.

**12.** An optical semiconductor device comprising: an optical semiconductor element; and the encapsulant for optical semiconductor devices according to any one of claims 1 to 11, which is provided so as to encapsulate the optical semiconductor element.

[FIG. 1]

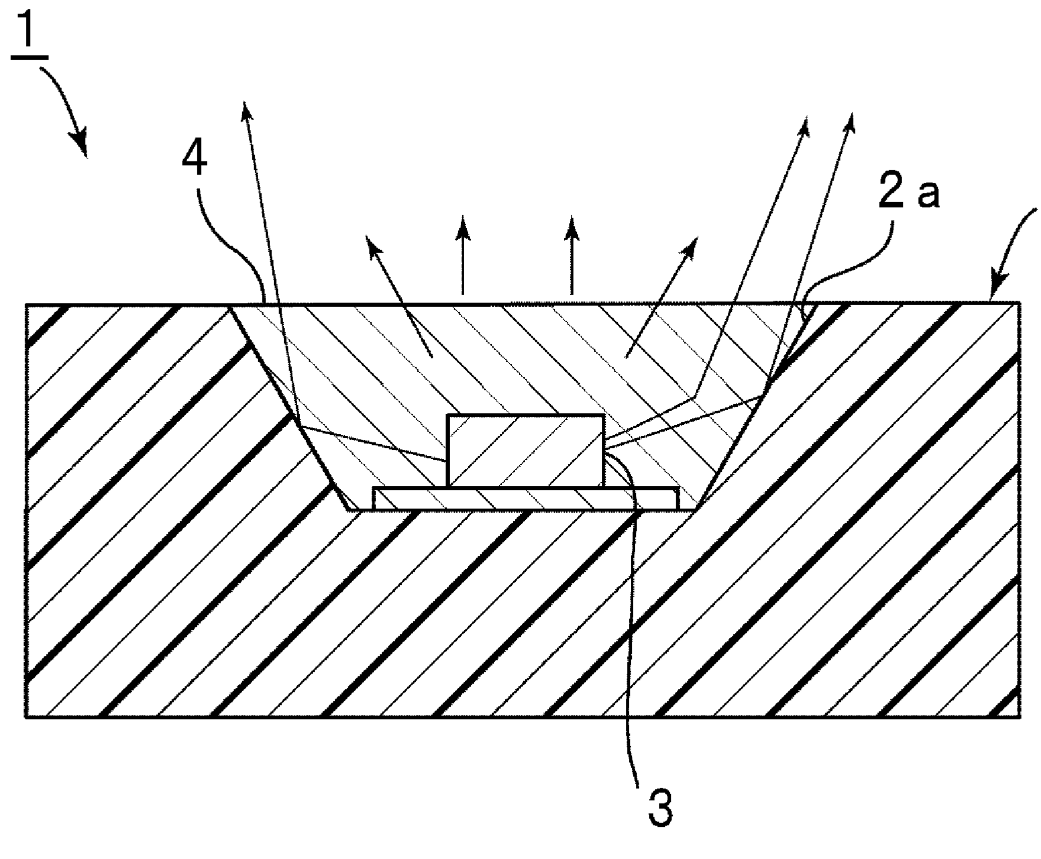

**INTERNATIONAL SEARCH REPORT**

International application No.
PCT/JP2012/067681

A. CLASSIFICATION OF SUBJECT MATTER
*C08L83/07*(2006.01)i, *C08G77/12*(2006.01)i, *C08G77/20*(2006.01)i, *C08L83/05*(2006.01)i, *H01L33/56*(2010.01)i

According to International Patent Classification (IPC) or to both national classification and IPC

B. FIELDS SEARCHED

Minimum documentation searched (classification system followed by classification symbols)
C08L83/07, C08G77/12, C08G77/20, C08L83/05, H01L33/56

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2011-099075 A (Nitto Denko Corp.), 19 May 2011 (19.05.2011), & US 2011/0112268 A1 & EP 2319888 A1 & CN 102050948 A & KR 10-2011-0051155 A | 1-12 |
| A | JP 2010-144130 A (Taica Corp.), 01 July 2010 (01.07.2010), (Family: none) | 1-12 |
| A | JP 2004-359756 A (Wacker Asahikasei Silicone Co., Ltd.), 24 December 2004 (24.12.2004), & US 2006/0081864 A1 & EP 1651724 A2 & WO 2004/107458 A2 & KR 10-2006-0016107 A & CN 1798810 A | 1-12 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 19 September, 2012 (19.09.12) | 23 October, 2012 (23.10.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

INTERNATIONAL SEARCH REPORT

International application No. PCT/JP2012/067681

C (Continuation). DOCUMENTS CONSIDERED TO BE RELEVANT

| Category* | Citation of document, with indication, where appropriate, of the relevant passages | Relevant to claim No. |
|---|---|---|
| A | JP 11-029710 A (Dow Corning Toray Silicone Co., Ltd.), 02 February 1999 (02.02.1999), & US 6001918 A & EP 890617 A2 & DE 69826370 D | 1-12 |
| A | JP 2006-299099 A (Shin-Etsu Chemical Co., Ltd.), 02 November 2006 (02.11.2006), (Family: none) | 1-12 |
| A | JP 2009-215434 A (Shin-Etsu Chemical Co., Ltd.), 24 September 2009 (24.09.2009), (Family: none) | 1-12 |
| P,X | WO 2012/070525 A1 (Daicel Corp.), 31 May 2012 (31.05.2012), claims; paragraphs [0015] to [0078]; examples (Family: none) | 1-12 |
| P,A | JP 2012-111836 A (Sekisui Chemical Co., Ltd.), 14 June 2012 (14.06.2012), (Family: none) | 1-12 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2003073452 A
- JP 2002314142 A